# EUROPEAN PATENT APPLICATION

(11) **EP 4 550 151 A1**
(43) Date of publication of application: **07.05.2025**
(21) Application number: 24191831.7
(22) Date of filing: 30.07.2024
(51) Int. Cl.: G06F 11/16, G06F 11/20, G11C 5/04, G11C 29/00, G06F 12/06, G06F 3/06, G06F 12/02

(54) **SPARING TECHNIQUES IN STACKED MEMORY ARCHITECTURES**

(30) Priority: 02.11.2023 US 202363595650 P; 17.07.2024 US 202418775981
(71) Applicant: Micron Technology, Inc., Boise, ID 83716-9632 (US)
(72) Inventor: Mylavarapu, Sai Krishna, Boise, 83716-9632 (US); Gunasekaran, Shivasankar, Boise, 83716-9632 (US); Akel, Ameen D., Boise, 83716-9632 (US); Keeth, Brent, Boise, 83716-9632 (US); Johnson, Johnson P., Boise, 83716-9632 (US); Griffin, Amy Rae, Boise, 83716-9632 (US)
(74) Representative: Pio, Federico

(57) **Abstract**

Methods, systems, and devices for sparing techniques in stacked memory architectures are described. A memory system may implement a stacked memory architecture that includes a set of array dies stacked along a direction and a logic die coupled with the set of array dies. Each array die may include one or more memory arrays accessible using one or more first interface blocks of the array die. To support sparing, the memory system may remap access from one or more first memory arrays of the set of array dies to one or more second memory arrays of the set of array dies. Logic circuitry of the logic die may be operable to perform the remapping in accordance with one or more levels of granularity, such as at a die level, channel level, pseudo-channel level, bank level, or a combination thereof.

## Description

### CROSS REFERENCE

The present Application for Patent claims priority to U.S. Provisional Patent Application No. 63/595,650 by Mylavarapu et al., entitled "SPARING TECHNIQUES IN STACKED MEMORY ARCHITECTURES," filed November 2, 2023, and U.S. Non-Provisional Patent Application No. 18/775,981by Mylavarapu et al., entitled "SPARING TECHNIQUES IN STACKED MEMORY ARCHITECTURES," filed 17 July, 2024, each of which is assigned to the assignee hereof.

### TECHNICAL FIELD

The following relates to one or more systems for memory, including sparing techniques in stacked memory architectures.

### BACKGROUND

Memory devices are used to store information in devices such as computers, user devices, wireless communication devices, cameras, digital displays, and others. Information is stored by programming memory cells within a memory device to various states. For example, binary memory cells may be programmed to one of two supported states, often denoted by a logic 1 or a logic 0. In some examples, a single memory cell may support more than two states, any one of which may be stored by the memory cell. To store information, a memory device may write (e.g., program, set, assign) states to the memory cells. To access stored information, a memory device may read (e.g., sense, detect, retrieve, determine) states from the memory cells.

Various types of memory devices exist, including magnetic hard disks, random access memory (RAM), read-only memory (ROM), dynamic RAM (DRAM), synchronous dynamic RAM (SDRAM), static RAM (SRAM), ferroelectric RAM (FeRAM), magnetic RAM (MRAM), resistive RAM (RRAM), flash memory, phase change memory (PCM), self-selecting memory, chalcogenide memory technologies, not-or (NOR) and not-and (NAND) memory devices, and others. Memory cells may be described in terms of volatile configurations or non-volatile configurations. Memory cells in a non-volatile configuration may maintain stored logic states for extended periods of time even in the absence of an external power source. Memory cells in a volatile configuration may lose stored states when disconnected from an external power source.

### BRIEF DESCRIPTION OF THE DRAWINGS

FIG. 1 shows an example of a system that supports sparing techniques in stacked memory architectures in accordance with examples as disclosed herein.
FIG. 2 shows an example of a system that supports sparing techniques in stacked memory architectures in accordance with examples as disclosed herein.
FIG. 3 shows an example of an interface architecture that supports sparing techniques in stacked memory architectures in accordance with examples as disclosed herein.
FIG. 4 shows an example of a manufacturing process that supports sparing techniques in stacked memory architectures in accordance with examples as disclosed herein.
FIGs. 5A, 5B, 5C, and 5D show examples of sparing diagrams that support sparing techniques in stacked memory architectures in accordance with examples as disclosed herein.
FIG. 6 shows a block diagram of a system that supports sparing techniques in stacked memory architectures in accordance with examples as disclosed herein.
FIG. 7 shows a block diagram of a logic die that supports sparing techniques in stacked memory architectures in accordance with examples as disclosed herein.
FIGs. 8 and 9 show flowcharts illustrating methods that support sparing techniques in stacked memory architectures in accordance with examples as disclosed herein.

### DETAILED DESCRIPTION

Some memory systems may include a stack of semiconductor dies, including one or more memory dies (which may be referred to as array dies) above a logic die that is operable to access a set of memory arrays distributed across the one or more memory dies. Such a stacked architecture may be implemented as part of a tightly-coupled dynamic random access memory (TCDRAM) system, and may support solutions for memory-centric logic, such as graphics processing units (GPUs), among other implementations. In some examples, a TCDRAM system may be closely coupled (e.g., physically coupled, electrically coupled) with a processor, such as a GPU or other host, as part of a physical memory map accessible to the processor. Such coupling may include one or more processors being implemented in a same semiconductor die as at least a portion of a TCDRAM system (e.g., as part of a logic die), or a processor being implemented in a die that is directly coupled (e.g., fused) with another die that includes at least a portion of a TCDRAM system. Unlike cache-based memory, TCDRAM may not be backed by a level of external memory with the same physical addresses. For example, a TCDRAM may be associated with and located within a dedicated base address, where each portion of the TCDRAM may be non-overlapping within the address.

To manufacture a memory system that implements a stacked architecture (e.g., a TCDRAM system), the granularity at which semiconductor dies are stacked (e.g., and coupled) may be at the wafer level. For example, due to the tight coupling of the stacked semiconductor dies, semiconductor wafers that include multiple semiconductor dies may be stacked and coupled (e.g., bonded) together, and respective stacks of coupled dies may be individually separated (e.g., cut, divided) from the stack of semiconductor wafers (e.g., rather than selecting individual semiconductor dies for stacking and coupling). Wafers with a relatively high yield of dies, such as wafers that include relatively fewer dies with defects (e.g., failures), may be selected for inclusion in a wafer stack. However, a non-perfect yield of the wafers may be compounded in the stack of wafers, such that a yield of a resulting die stack separated from the wafer stack may be reduced. For example, an eight-high array die stack that is separated from a stack of wafers that each have approximately 90% yield may have a yield of approximately 40%. As such, performance (e.g., latency, bandwidth, storage capacity) or yield of memory systems may be adversely affected by such stacking.

In accordance with techniques described herein, a memory system that implements a stacked architecture may support sparing techniques to improve yield of an array die stack (e.g., compensate for relatively lower yield of the array die stack). For example, one or more spare arrays or dies may be included in the array die stack, and a logic die may include logic circuitry to support sparing (e.g., replacing) one or more failed components of the array dies (e.g., a bank, a pseudo-channel, a channel, an array, an array die) with one or more components of the one or more spare arrays or dies (e.g., a spare bank, a spare-pseudo-channel, a spare channel, a spare array, a spare array die). For instance, the logic die may include interface blocks (e.g., memory interface blocks (MIBs)) that are used to access one or more memory arrays of the array dies. The logic circuitry may remap accessing of the failed components to the components of the one or more spare dies such that accesses to an address space corresponding to the failed components (e.g., using one or more first interface blocks) may instead access the one or more components of the one or more spare dies (e.g., using one or more second interface blocks) in accordance with the remapping. Additionally, or alternatively, one or more array dies of the array die stack may include spare portions to which the logic circuitry may remap accessing of failed components.

Supporting sparing in accordance with the described techniques may increase the yield of a memory system that implements a stacked architecture, such as a TCDRAM system, for example, by supporting a replacement of failed components with spare components. As such, performance of the memory system may be improved. Additionally, a time-to-market of products that implement TCDRAM systems may be reduced. For example, products released to the market may be associated with yield constraints, and improving yield via sparing techniques described herein may enable such constraints to be satisfied without improving manufacturing techniques to increase the yield of individual semiconductor wafers, which may involve a delay before such improvements are realized. Additionally, or alternatively, sparing techniques described herein may reduce costs as a final yield of an array die stack may be unknown until after it is coupled (e.g., wire-to-wire bonded) with a host system (e.g., included on a logic die). Accordingly, if the yield does not meet yield constraints, the entire system, including the logic die and array dies, may be discarded. Thus, improving array die stack yield using sparing techniques described herein may increase the likelihood that yield constraints are met, thereby reducing costs of manufacturing TCDRAM systems.

Features of the disclosure are illustrated and described in the context of systems and dies. Features of the disclosure are further illustrated and described in the context of an interface architecture, a manufacturing process, sparing diagrams, block diagrams, and flowcharts.

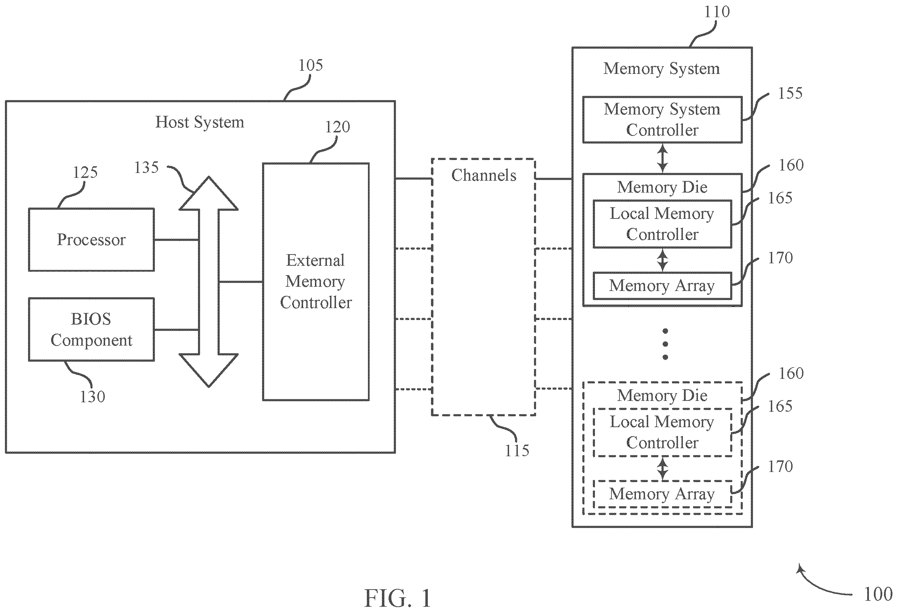

**FIG.** 1 illustrates an example of a system 100 that supports sparing techniques in stacked memory architectures in accordance with examples as disclosed herein. The system 100 may include portions of an electronic device, such as a computing device, a mobile computing device, a wireless communications device, a graphics processing device, a vehicle, or other systems. The system 100 includes a host system 105, a memory system 110, and one or more channels 115 coupling the host system 105 with the memory system 110 (e.g., to provide a communicative coupling). The system 100 may include one or more memory systems 110, but aspects of the one or more memory systems 110 may be described in the context of a single memory system 110.

The host system 105 may be an example of a processor (e.g., circuitry, processing circuitry, one or more processing components) that uses memory to execute processes, such as a processing system of a computing device, a mobile computing device, a wireless communications device, a graphics processing device, a wearable device, an internet-connected device, a vehicle controller, a system on a chip (SoC), or other stationary or portable electronic device, among other examples. The host system 105 may include one or more of an external memory controller 120, a processor 125, a basic input/output system (BIOS) component 130, or other components (e.g., a peripheral component, an input/output controller, not shown). The components of the host system 105 may be coupled with one another using a bus 135.

An external memory controller 120 may be configured to enable communication of information (e.g., data, commands, control information, configuration information) between components of the system 100 (e.g., between components of the host system 105, such as the processor 125, and the memory system 110). An external memory controller 120 may process (e.g., convert, translate) communications exchanged between the host system 105 and the memory system 110. In some examples, an external memory controller 120, or other component of the system 100, or associated functions described herein, may be implemented by or be part of the processor 125. For example, an external memory controller 120 may be hardware, firmware, or software (e.g., instructions), or some combination thereof implemented by a processor 125 or other component of the system 100 or the host system 105. Although an external memory controller 120 is illustrated outside the memory system 110, in some examples, an external memory controller 120, or its functions described herein, may be implemented by one or more components of a memory system 110 (e.g., a memory system controller 155, a local memory controller 165) or vice versa. In various examples, the host system 105 or an external memory controller 120 may be referred to as a host.

A processor 125 may be operable to provide functionality (e.g., control functionality) for the system 100 or the host system 105. A processor 125 may be a general-purpose processor, a digital signal processor (DSP), an application-specific integrated circuit (ASIC), a field-programmable gate array (FPGA) or other programmable logic device, discrete gate or transistor logic, discrete hardware components, or any combination thereof. In some examples, a processor 125 may be an example of a central processing unit (CPU), a graphics processing unit (GPU), a general-purpose GPU (GPGPU), or an SoC, among other examples.

In some examples, the system 100 or the host system 105 may include an input component, an output component, or a combination thereof. Input components may include a sensor, a microphone, a keyboard, another processor (e.g., on a printed circuit board), an interface (e.g., a user interface, an interface between other devices), or a peripheral that interfaces with system 100 via one or more peripheral components, among other examples. Output components may include a display, audio speakers, a printing device, another processor on a printed circuit board, or a peripheral that interfaces with the system 100 via one or more peripheral components, among other examples.

The memory system 110 may be a component of the system 100 that is operable to provide physical memory locations (e.g., addresses) that may be used or referenced by the system 100. The memory system 110 may include a memory system controller 155 and one or more memory dies 160 (e.g., memory chips) to support a capacity for data storage. The memory system 110 may be configurable to work with one or more different types of host systems 105, and may respond to and execute commands provided by the host system 105 (e.g., via an external memory controller 120). For example, the memory system 110 (e.g., a memory system controller 155) may receive a write command indicating that the memory system 110 is to store data received from the host system 105, or receive a read command indicating that the memory system 110 is to provide data stored in a memory die 160 to the host system 105, or receive a refresh command indicating that the memory system 110 is to refresh data stored in a memory die 160, among other types of commands and operations.

A memory system controller 155 may include components (e.g., circuitry, logic) operable to control operations of the memory system 110. A memory system controller 155 may include hardware, firmware, or instructions that enable the memory system 110 to perform various operations, and may be operable to receive, transmit, or execute commands, data, or control information related to operations of the memory system 110. A memory system controller 155 may be operable to communicate with one or more of an external memory controller 120, one or more memory dies 160, or a processor 125. In some examples, a memory system controller 155 may control operations of the memory system 110 in cooperation with a local memory controller 165 of a memory die 160.

Each memory die 160 may include a local memory controller 165 and a memory array 170. A memory array 170 may be a collection of memory cells, with each memory cell being operable to store one or more bits of data. A memory die 160 may include a two-dimensional (2D) array of memory cells, or a three-dimensional (3D) array of memory cells. In some examples, a 2D memory die 160 may include a single memory array 170. In some examples, a 3D memory die 160 may include two or more memory arrays 170, which may be stacked or positioned beside one another (e.g., relative to a substrate).

A local memory controller 165 may include components (e.g., circuitry, logic) operable to control operations of a memory die 160. In some examples, a local memory controller 165 may be operable to communicate (e.g., receive or transmit data or commands or both) with a memory system controller 155. In some examples, a memory system 110 may not include a memory system controller 155, and a local memory controller 165 or an external memory controller 120 may perform various functions described herein. As such, a local memory controller 165 may be operable to communicate with a memory system controller 155, with other local memory controllers 165, or directly with an external memory controller 120, or a processor 125, or any combination thereof. Examples of components that may be included in a memory system controller 155 or a local memory controller 165 or both may include receivers for receiving signals (e.g., from the external memory controller 120), transmitters for transmitting signals (e.g., to the external memory controller 120), decoders for decoding or demodulating received signals, encoders for encoding or modulating signals to be transmitted, sense components for sensing states of memory cells of a memory array 170, write components for writing states to memory cells of a memory array 170, or various other components operable for supporting described operations of a memory system 110.

A host system 105 (e.g., an external memory controller 120) and a memory system 110 (e.g., a memory system controller 155) may communicate information (e.g., data, commands, control information, configuration information) using one or more channels 115. Each channel 115 may be an example of a transmission medium that carries information, and each channel 115 may include one or more signal paths (e.g., a transmission medium, an electrical conductor, an electrically conductive path) between terminals associated with the components of the system 100. For example, a channel 115 may be associated with a first terminal (e.g., including one or more pins, including one or more pads) at the host system 105 and a second terminal at the memory system 110. A terminal may be an example of a conductive input or output point of a device of the system 100, and a terminal may be operable to act as part of a channel 115. In some implementations, at least the channels 115 between a host system 105 and a memory system 110 may include or be referred to as a host interface (e.g., a physical host interface). In some implementations, a host interface may include or be associated with interface circuitry (e.g., signal drivers, signal latches) at the host system 105 (e.g., at an external memory controller 120), or at the memory system 110 (e.g., at a memory system controller 155), or both.

In some examples, a channel 115 (e.g., associated signal paths and terminals) may be dedicated to communicating one or more types of information. For example, the channels 115 may include one or more command and address channels, one or more clock signal channels, one or more data channels, among other channels or combinations thereof. In some examples, signaling may be communicated via the channels 115 using single data rate (SDR) signaling or double data rate (DDR) signaling. In SDR signaling, one modulation symbol (e.g., signal level) of a signal may be registered for each clock cycle (e.g., on a rising or falling edge of a clock signal). In DDR signaling, two modulation symbols of a signal may be registered for each clock cycle (e.g., on both a rising edge and a falling edge of a clock signal).

In some examples, at least a portion of the system 100 may implement a stacked die architecture in which multiple semiconductor dies are physically and communicatively coupled. In some implementations, one or more semiconductor dies may include multiple instances of interface circuitry (e.g., of a memory system 110, memory interface blocks) that are each associated with accessing a respective set of one or more memory arrays 170 of one or more other semiconductor dies. In some cases, circuitry for accessing one or more memory arrays 170 may be distributed among multiple semiconductor dies of a stack (e.g., a stack of multiple directly-coupled semiconductor dies). For example, a first die may include a logic block (e.g., a common logic block, a central logic block, logic circuitry) operable to configure a set of multiple first interface blocks (e.g., MIBs, instances of first interface circuitry) of the first die. In some examples, the system may include a respective controller (e.g., a memory controller, a host interface controller, at least a portion of a memory system controller 155, at least a portion of an external memory controller 120, or a combination thereof) for each first interface block to support access operations (e.g., to access one or more memory arrays 170) via the first interface block. The system 100 may also include non-volatile storage, one or more sensors, or a combination thereof to support various operations of the system 100.

In some examples, multiple semiconductor dies of a memory system 110 (e.g., a TCDRAM system) may include one or more array dies (e.g., memory dies 160) stacked with a logic die (e.g., that includes the host system 105, that is coupled with another die that includes the host system 105) that includes interface blocks operable to access a set of memory arrays 170 distributed across the one or more second dies. In some cases, one or more components of an array die may fail (e.g., be defective, malfunction) such that successful accessing of one or more of the memory arrays 170 of the array die using an interface block of the logic die may be unreliable or impossible. As such, a yield of the array die may be reduced. Yield reductions may be compounded in a memory system 110 that includes a stack of array dies. For example, to manufacture such a memory system 110, semiconductor wafers may be stacked and coupled (e.g., bonded) together, and respective stacks of array dies may be individually separated (e.g., cut out) from the stack of semiconductor wafers (e.g., rather than selecting individual semiconductor dies for stacking and coupling). Although wafers with a relatively high yield may be selected for inclusion in such a wafer stack, a non-perfect yield of the wafers may be compounded in the stack of wafers such that a yield of a resulting die stack separated from the wafer stack may be reduced. As a result, performance (e.g., latency, bandwidth, storage capacity) or yield of the memory system 110 may be adversely affected by such stacking.

In accordance with techniques described herein, a system 100 that implements a stacked architecture may support sparing techniques to improve yield of an array die stack (e.g., a memory system 110). For example, one or more spare array dies may be included in the array die stack, and a logic die may include logic circuitry to support sparing (e.g., replacing) one or more failed components of the array dies (e.g., a bank, a pseudo-channel, a channel, an array, an array die) with one or more components of the one or more spare dies (e.g., a spare bank, a spare-pseudo-channel, a spare channel, a spare array, a spare array die). For instance, the logic circuitry may remap accessing of the failed components to the components of the one or more spare dies such that accesses to an address space (e.g., available to a host system 105) corresponding to the failed components may instead access the one or more components of the one or more spare dies in accordance with the remapping. Additionally, or alternatively, one or more array dies of the array die stack may include spare portions to which the logic circuitry may remap accessing of failed components.

In addition to applicability in systems as described herein, techniques for sparing in stacked memory architectures may be generally implemented to support artificial intelligence applications. As the use of artificial intelligence increases to support machine learning, analytics, decision making, or other related applications, electronic devices that support artificial intelligence applications and processes may be desired. For example, artificial intelligence applications may be associated with accessing relatively large quantities of data for analytical purposes and may benefit from memory devices capable of effectively and efficiently storing relatively large quantities of data or accessing stored data relatively quickly. Implementing the techniques described herein may support artificial intelligence and/or machine learning techniques by improving memory access bandwidth and increasing memory capacity, for example, by supporting the replacement of failed components with spare components to maintain bandwidth and capacity or mitigate bandwidth and capacity loss despite the failure of the components, among other benefits.

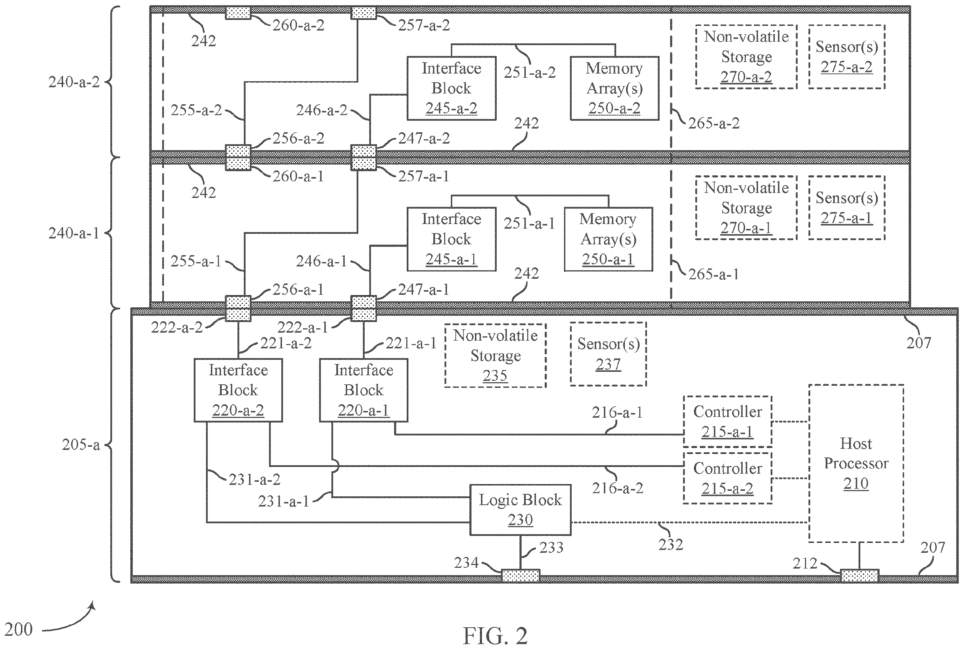

**FIG. 2** illustrates an example of a system 200 (e.g., a semiconductor system, a system of coupled semiconductor dies) that supports sparing techniques in stacked memory architectures in accordance with examples as disclosed herein. The system 200 illustrates an example of a die 205 (e.g., a semiconductor die, a host die, a processor die, a logic die) that is coupled with one or more dies 240 (e.g., dies 240-a-1 and 240-a-2, semiconductor dies, memory dies, array dies). A die 205 or a die 240 may be formed using a respective semiconductor substrate (e.g., a substrate of crystalline semiconductor material such as silicon, germanium, silicon-germanium, gallium arsenide, or gallium nitride), or a silicon-on-insulator (SOI) substrate (e.g., silicon-on-glass (SOG), silicon-on-sapphire (SOS)), or epitaxial semiconductor materials formed on another substrate, among other examples. Although the illustrated example of a system 200 includes two dies 240, a system 200 in accordance with the described techniques may include any quantity of one or more dies 240 coupled with a die 205. Further, although non-limiting examples of the system 200 herein are generally described in terms of applicability to memory systems, memory sub-systems, memory devices, or a combination thereof, examples of the system 200 are not so limited. For example, aspects of the present disclosure may be applied as well to any computing system, computing sub-system, processing system, processing sub-system, component, device, structure, or other types of systems or sub-systems used for applications such as data collecting, data processing, data storage, networking, communication, power, artificial intelligence, system-on-a-chip, control, telemetry, sensing and monitoring, digital entertainment, or any combination thereof.

The system 200 illustrates an example of interface circuitry between a host and memory (e.g., via a host interface, via a physical host interface) that is implemented in (e.g., divided between) multiple semiconductor dies (e.g., a stack of directly coupled dies). For example, the die 205 may include a set of one or more interface blocks 220 (e.g., interface blocks 220-a-1 and 220-a-2, memory interface blocks), and each die 240 may include a set of one or more interface blocks 245 and one or more memory arrays 250 (e.g., die 240-a-1 including an interface block 245-a-1 coupled with a set of one or more memory arrays 250-a-1, die 240-a-2 including an interface block 245-a-2 coupled with a set of one or more memory arrays 250-a-2). The memory arrays 250 may be examples of memory arrays 170, and may include memory cells of various architectures, such as RAM, DRAM, SDRAM, SRAM, FeRAM, MRAM, RRAM, PCM, chalcogenide, NOR, or NAND memory cells, or any combination thereof.

Although the example of system 200 is illustrated with one interface block 245 included in each die 240, a die 240 in accordance with the described techniques may include any quantity of one or more interface blocks 245, each coupled with a respective set of one or more memory arrays 250, and each coupled with a respective interface block 220 of a die 205. Thus, the interface circuitry of a system 200 may include one or more interface blocks 220 of a die 205, with each interface block 220 being coupled with (e.g., in communication with) a corresponding interface block 245 of a die 240 (e.g., external to the die 205). In some examples, a coupled combination of an interface block 220 and an interface block 245 (e.g., coupled via a bus associated with one or more channels, such as one or more data channels, one or more control channels, one or more clock channels, or a combination thereof) may include or be referred to as a data path associated with a respective set of one or more memory arrays 250.

In some implementations, the die 205 may include a host processor 210. A host processor 210 may be an example of a host system 105, or a portion thereof (e.g., a processor 125, aspects of an external memory controller 120, or both). The host processor 210 may be configured to perform operations that implement storage of the memory arrays 250. For example, the host processor 210 may receive data read from the memory arrays 250, or may transmit data to be written to the memory arrays 250, or both (e.g., in accordance with an application or other operations of the host processor 210). Additionally, or alternatively, a host processor 210 may be external to a die 205, such as in another semiconductor die or other component that is coupled with (e.g., communicatively coupled with, directly coupled with, bonded with) the die 205 via one or more contacts 212.

A host processor 210 may be configured to communicate (e.g., transmit, receive) signaling with the interface blocks 220 via one or more host interfaces 216 (e.g., a physical host interface), which may implement aspects of channels 115 described with reference to FIG. 1. For example, the host processor 210 may be configured to transmit access signaling (e.g., control signaling, access command signaling, configuration signaling) via host interfaces 216, which may be received by the interface blocks 220 to support access operations (e.g., read operations, write operations) on the memory arrays 250. In some examples, a host interface 216 may include a respective set of one or more signal paths for each interface block 220, such that the host processor 210 may communicate with each interface block 220 via the respective set of signal paths (e.g., in accordance with a selection of the respective set to perform access operations via an interface block 220 that is selected by the host processor 210). Additionally, or alternatively, a host interface 216 may include one or more signal paths that are shared among multiple interface blocks 220 (not shown), and an interface block 220, or a host processor 210, or both may interpret, ignore, respond to, or inhibit response to signaling via shared signal paths of the host interface 216 based on a logical indication (e.g., an addressing indication associated with the interface block 220 or an interface enable signal, which may be provided by the host processor 210 or the corresponding interface block 220, depending on signaling direction).

In some examples, a respective host interface 216 may be coupled between a set of one or more interface blocks 220 and a controller 215 (e.g., host interface 216-a-1 coupled between interface block 220-a-1 and controller 215-a-1, host interface 216-a-2 coupled between interface block 220-a-2 and controller 215-a-2). The one or more interface blocks 220 and the controller 215 may communicate (e.g., collaborate) to perform one or more operations (e.g., scheduling operations, access operations, operations initiated by a host processor 210) associated with a memory array 250. A controller 215 may be an example of control circuitry (e.g., memory controller circuitry, host interface control circuitry), and may be associated with implementing respective instances of one or more aspects of an external memory controller 120, or of a memory system controller 155, or a combination thereof for each interface block 220. In some examples, controllers 215 may be implemented in a die 205 whether a host processor 210 is included in the die 205, or is external to the die 205, and the interface block 220 may communicate with the host processor 210 via one or more controllers 215. In some other examples, controllers 215 may be implemented external to a die 205 (e.g., in another die, not shown, coupled with respective interface blocks 220 via respective terminals for each of the respective host interfaces 216), which may be in a same die as or a different die from a die that includes a host processor 210. In some other examples, aspects of one or more controllers 215 may be included in the host processor 210. Although the example of system 200 is illustrated as including a controller 215 for each interface block 220, in various examples, a controller 215 may be coupled with any quantity of one or more interface blocks 220, and a given interface block 220 may be operable based on single controller 215, or by one or more of a set of multiple controllers 215 (e.g., in accordance with a controller multiplexing scheme).

In some examples, a host processor 210 may determine to access an address (e.g., a logical address of a memory array 250, a physical address of a memory array 250, an address of an interface block 220), and determine which controller 215 to transmit access signaling to for accessing the address (e.g., a controller 215 or interface block 220 corresponding to the address). In some examples, the address may be associated with a row of memory cells of the memory array 250. The host processor 210 may transmit access signaling to the determined controller 215 and, in turn, the determined controller 215 may transmit access signaling to the corresponding interface block 220. The corresponding interface block 220 may subsequently transmit access signaling to the coupled interface block 245 to access the determined address (e.g., in a corresponding memory array 250).

A die 205 may also include a logic block 230 (e.g., a shared logic block, a central logic block, common logic circuitry), which may be configured to communicate (e.g., transmit, receive) signaling with the interface blocks 220 of the die 205. In some cases, the logic block 230 may be configured to communicate information (e.g., commands, instructions, indications, data) with one or more interface blocks 220 to facilitate operations of the system 200. For example, a logic block 230 may be configured to transmit configuration signaling (e.g., initialization signaling, evaluation signaling, mapping signaling), which may be received by interface blocks 220 to support configuration of the interface blocks 220 or other aspects of operating the dies 240 (e.g., via the respective interface blocks 245). A logic block 230 may be coupled with each interface block 220 via a respective bus 231 (e.g., bus 231-a-1 associated with the interface block 220-a-1, bus 231-a-2 associated with the interface block 220-a-2). In some examples, respective buses 231 may each include a respective set of one or more signal paths, such that a logic block 230 may communicate with each interface block 220 via the respective set of signal paths. Additionally, or alternatively, respective buses 231 may include one or more signal paths that are shared among multiple interface blocks 220 (not shown).

In some implementations, a logic block 230 may be configured to communicate (e.g., transmit, receive) signaling with a host processor 210 (e.g., via a bus 232, via a contact 212 for a host processor 210 external to a die 205) such that the logic block 230 may support an interface between the interface blocks 220 and the host processor 210. For example, a host processor 210 may be configured to transmit initialization signaling (e.g., boot commands), or other configuration or operational signaling, which may be received by a logic block 230 to support initialization, configuration, or other operations of the interface blocks 220. Additionally, or alternatively, in some implementations, a logic block 230 may be configured to communicate (e.g., transmit, receive) signaling with a component outside the system 200 via a bus 233 (e.g., and via a contact 234), such that the logic block 230 may support an interface that bypasses a host processor 210. Additionally, or alternatively, a logic block 230 may communicate with a host processor 210, and may communicate with one or more memory arrays 250 of one or more dies 240 (e.g., to perform self-test operations for the memory arrays 250). In some examples, such implementations may support evaluations, configurations, or other operations of the system 200, via contacts 234 that are accessible at a physical interface of the system, during manufacturing, assembly, validation, or other operation associated with the system 200 (e.g., before coupling with a host processor 210, without implementing a host processor 210, for operations independent of a host processor). Additionally, or alternatively, a logic block 230 may implement one or more aspects of a controller 215. For example, a logic block 230 may include or operate as one or more controllers 215 and may perform operations ascribed to a controller 215.

Each interface block 220 may be coupled with at least a respective bus 221 of the die 205, and a respective bus 246 of a die 240, that are configured to communicate signaling with a corresponding interface block 245 (e.g., via one or more associated signal paths). For example, the interface block 220-a-1 may be coupled with the interface block 245-a-1 via a bus 221-a-1 and a bus 246-a-1, and the interface block 220-a-2 may be coupled with the interface block 245-a-2 via a bus 221-a-2 and a bus 246-a-2. In some examples, a die 240 may include a bus that bypasses operational circuitry of the die 240 (e.g., bypasses interface blocks 245 of a given die 240), such as a bus 255. For example, the interface block 220-a-2 may be coupled with the interface block 245-a-2 of the die 240-a-2 via a bus 255-a-1 of the die 240-a-1, which may bypass interface blocks 245 of the die 240-a-1. Such techniques may be extended for interconnection among more than two dies 240 (e.g., for interconnection via a respective bus 255 of multiple dies 240).

The respective signal paths of buses 221, 246, and 255 may be coupled with one another, from one die to another, via various arrangements of contacts at the surfaces of interfacing dies. For example, the bus 221-a-1 may be coupled with the bus 246-a-1 via a contact 222-a-1 of (e.g., at a surface of) the die 205 and a contact 247-a-1 of the die 240-a-1, the bus 221-a-2 may be coupled with the bus 255-a-1 via a contact 222-a-2 of the die 205 and a contact 256-a-1 of the die 240-a-1, the bus 255-a-1 may be coupled with the bus 246-a-2 via a contact 257-a-1 of the die 240-a-1 and a contact 247-a-2 of the die 240-a-2, and so on. Although each respective bus is illustrated with a single line, coupled via singular contacts, it is to be understood that each signal path of a given bus may be associated with respective contacts to support a separate communicative coupling via each signal path of the given bus. In some examples, a bus 255 may traverse a portion of a die 240 (e.g., in an in-plane direction, along a direction different from a thickness direction, in a waterfall arrangement), which may support an arrangement of contacts 222 along a surface of a die 205 being coupled with interface blocks 245 of different dies 240 along a stack direction (e.g., via respective contacts 256 and 257 that are non-overlapping when viewed along a thickness direction).

The interconnection of interfacing contacts may be supported by various techniques. For example, in a hybrid bonding implementation, interfacing contacts may be coupled by a fusion of conductive materials (e.g., electrically conductive materials) of the interfacing contacts (e.g., without solder or other intervening material between contacts). For example, in an assembled condition, the coupling of the die 205 with the die 240-a-1 may include a conductive material of the contact 222-a-2 being fused with a conductive material of the contact 256-a-1, and the coupling of the die 240-a-1 with the die 240-a-2 may include a conductive material of the contact 257-a-1 being fused with a conductive material of the contact 247-a-2, and so on. In some examples, such coupling may include an inoperative fusion of contacts (e.g., a non-communicative coupling, a physical coupling), such as a fusion of the contact 260-a-1 with the contact 256-a-2, neither of which are coupled with operative circuitry of the dies 240-a-1 or 240-a-2. In some examples, such techniques may be implemented to improve coupling strength or uniformity (e.g., implementing contacts 260, which may not be operatively coupled with an interface block 245 or an interface block 220), or such a coupling may be a byproduct of a repetition of components that, in various configurations, may be operative or inoperative. (e.g., where, for dies 240 with a common arrangement of contacts 256 and 257, contacts 256-a-1 and 257-a-1 provide a communicative path between the interface block 245-a-2 and the interface block 220-a-2, but the contacts 256-a-2 and 257-a-2 do not provide a communicative path between an interface block 245 and an interface block 220).

In some examples, a fusion of conductive materials between dies (e.g., between contacts) may be accompanied by a fusion of other materials at one or more surfaces of the interfacing dies. For example, in an assembled condition, the coupling of the die 205 with the die 240-a-1 may include a dielectric material 207 (e.g., an electrically non-conductive material) of the die 205 being fused with a dielectric material 242 of the die 240-a-1, and the coupling of the die 240-a-1 with the die 240-a-2 may include a dielectric material 242 of the die 240-a-1 being fused with a dielectric material 242 of the die 240-a-2. In some examples, such dielectric materials may include an oxide, a nitride, a carbide, an oxide-nitride, an oxide-carbide, or other conversion or doping of a semiconductor material of the die 205 or dies 240, among other materials that may support such fusion. However, coupling among dies 205 and dies 240 may be implemented in accordance with other techniques, which may implement solder, adhesives, thermal interface materials, and other intervening materials.

In some examples, dies 240 may be coupled in a stack (e.g., forming a "cube" or other arrangement of dies 240), and the stack may subsequently be coupled with a die 205. In some examples, a respective set of one or more dies 240 may be coupled with each die 205 of multiple dies 205 as formed in a wafer (e.g., in a chip-to-wafer bonding arrangement, before cutting the wafer of dies 205), and the dies 205 of the wafer, each coupled with their respective set of dies 240, may be separated from one another (e.g., by cutting at least the wafer of dies 205). In some other examples, a respective set of one or more dies 240 may be coupled with a respective die 205 after the die 205 is separated from a wafer of dies 205 (e.g., in a chip-to-chip bonding arrangement). In some other examples, a respective set of one or more wafers each including multiple dies 240 may be coupled in a stack (e.g., in a wafer-to-wafer bonding arrangement). In various examples, such techniques may be followed by separating stacks of dies 240 from the coupled wafers, or the stack of wafers having dies 240 may be coupled with another wafer including multiple dies 205 (e.g., in a second wafer-to-wafer bonding arrangement), which may be followed by separating systems 200 from the coupled wafers. In some other examples, wafer-to-wafer coupling techniques may be implemented by stacking one or more wafers of dies 240 (e.g., sequentially) over a wafer of dies 205 before separation into systems 200, among other examples for forming systems 200.

The buses 221, 246, and 255 may be configured to provide a configured signaling (e.g., a coordinated signaling, a logical signaling, modulated signaling, digital signaling) between an interface block 220 and a corresponding interface block 245, which may involve various modulation or encoding techniques by a transmitting interface block (e.g., via a driver component of the transmitting interface block). In some examples, such signaling may be supported by (e.g., accompanied by) clock signaling communicated via the respective buses (e.g., in coordination with signal transmission). For example, the buses may be configured to convey one or more clock signals transmitted by the interface block 220 for reception by the interface block 245 (e.g., to trigger signal reception by a latch or other reception component of the interface block 245, to support clocked operations of the interface block 245). Additionally, or alternatively, the buses may be configured to convey one or more clock signals transmitted by the interface block 245 for reception by the interface block 220 (e.g., to trigger signal reception by a latch or other reception component of the interface block 220, to support clocked operations of the interface block 220). Such clock signals may be associated with the communication (e.g., unidirectional communication, bidirectional communication) of various signaling, such as control signaling, command signaling, data signaling, or any combination thereof. For example, the buses may include one or more signal paths for communications of a data bus (e.g., one or more data channels, a DQ bus, via a data interface of the interface blocks) in accordance with one or more corresponding clock signals (e.g., data clock signals), or one or more signal paths for communications of a control bus (e.g., a command/address (C/A) bus, via a command interface of the interface blocks) in accordance with one or more clock signals (e.g., control clock signals), or any combination thereof.

Interface blocks 220, interface blocks 245, and logic block 230 each may include circuitry (signaling circuitry, multiplexing circuitry, processing circuitry, controller circuitry) in various configurations (e.g., hardware configurations, logic configurations, software or instruction configurations) that support the functionality allocated to the respective block for accessing or otherwise operating a corresponding set of memory arrays 250. For example, interface blocks 220 may include circuitry configured to perform a first subset of operations that support access of the memory arrays 250, and interface blocks 245 may include circuitry configured to support a second subset of operations that support access of the memory arrays 250. In some examples, the interface blocks 220 and 245 may support a functional split or distribution of functionality associated with a memory system controller 155, a local memory controller 165, or both across multiple dies (e.g., a die 205 and at least one die 240). In some implementations, a logic block 230 may be configured to coordinate or configure aspects of the operations of the interface blocks 220, of the interface blocks 245, or both, and may support implementing one or more aspects of a memory system controller 155. Such operations, or subsets of operations, may include operations performed in response to commands from the host processor 210, or operations performed without commands from the host processor 210 (e.g., operations determined or initiated by an interface block 220, operations determined or initiated by an interface block 245, operations determined or initiated by a logic block 230), or various combinations thereof.

In some implementations, the system 200 may include one or more instances of non-volatile storage (e.g., non-volatile storage 235 of a die 205, non-volatile storage 270 of one or more dies 240, or a combination thereof). In some examples, a logic block 230, interface blocks 220, interface blocks 245, or a combination thereof may be configured to communicate signaling with one or more instances of non-volatile storage. For example, a logic block 230, interface blocks 220, or interface blocks 245 may be coupled with one or more instances of non-volatile storage via one or more buses (not shown), or respective contacts (not shown), where applicable, which may each include one or more signal paths operable to communicate signaling (e.g., command signaling, data signaling). In some examples, a logic block 230, one or more interface blocks 220, one or more interface blocks 245, or a combination thereof may configure one or more operations based on information stored in one or more instances of non-volatile storage. Additionally, or alternatively, in some examples, a logic block 230, one or more interface blocks 220, one or more interface blocks 245, or a combination thereof may write information (e.g., configuration information) to be stored in one or more instances of non-volatile storage. In some examples, such non-volatile storage may include fuses, antifuses, or other types of one-time programmable storage elements, or any combination thereof.

In some implementations, the system 200 may include one or more sensors (e.g., one or more sensors 237 of a die 205, one or more sensors 275 of one or more dies 240, or a combination thereof). In some implementations, a logic block 230, interface blocks 220, interface blocks 245, or a combination thereof may be configured to receive one or more indications based on measurements of one or more sensors of the system 200. For example, a logic block 230, interface blocks 220, or interface blocks 245 may be coupled with one or more sensors via one or more buses (not shown), or respective contacts (not shown). Such sensors may include temperature sensors, current sensors, voltage sensors, counters, and other types of sensors. In some examples, a logic block 230, one or more interface blocks 220, one or more interface blocks 245, or a combination thereof may configure one or more operations based on output of the one or more sensors. For example, a logic block 230 may configure one or more operations of interface blocks 220 based on signaling (e.g., indications, data) received from the one or more sensors. Additionally, or alternatively, an interface block 220 may generate access signaling for transmitting to a corresponding interface block 245 based on one or more sensors.

In some examples, circuitry of interface blocks 220, interface blocks 245, or a logic block 230, or any combination thereof may include components (e.g., transistors) formed at least in part from doped portions of a substrate of the respective die. In some examples, a substrate of a die 205 may have characteristics that are different from those of a substrate of a die 240. Additionally, or alternatively, in some examples, transistors formed from a substrate of a die 205 may have characteristics (e.g., manufacturing characteristics, performance characteristics) that are different from transistors formed from a substrate of a die 240 (e.g., in accordance with different transistor architectures).

In some examples, the interface blocks 220 may support a layout for one or more components within the 220. For example, the layout may include pairing components to share an access port (e.g., a command port, a data port). Further, in some examples, the layout may support interfaces for a controller 215 (e.g., a host interface 216) that are different from interfaces for an interface block 245 (e.g., via the buses 221). For instance, a host interface 216 may be synchronous and have separate channels for read and write operations, while an interface via buses 221 and 246 may be asynchronous and support both read and write operations with a same channel.

A die 240 may include one or more units 265 (e.g., modules) that are separated from a semiconductor wafer having a pattern (e.g., a two-dimensional pattern) of units 265. Although each die 240 of the system 200 is illustrated with a single unit 265 (e.g., unit 265-a-1 of die 240-a-1, unit 265-a-2 of die 240-a-2), a die 240 in accordance with the described techniques may include any quantity of units 265, which may be arranged in various patterns (e.g., sets of one or more units 265 along a row direction, sets of one or more units 265 along a column direction, among other patterns). Each unit 265 may include at least the circuitry of a respective interface block 245, along with memory array(s) 250, a bus 251, a bus 246, and one or more contacts 247 corresponding to the respective interface block 245. In some examples, where applicable, each unit 265 may also include one or more buses 255, contacts 256, contacts 257, or contacts 260 (e.g., associated with a respective interface block 245 of a unit 265 of a different die 240), which may support various degrees of stackability or modularity among or via units 265 of other dies 240.

In some examples, the interface blocks 220 may include circuitry configured to receive first access command signaling from a host processor 210 or a controller 215 (e.g., via a host interface 216, via one or more contacts 212 from a host processor 210 or controller 215 external to a die 205), and to transmit second access command signaling to the respective (e.g., coupled) interface block 245 based on (e.g., in response to) the received first access command signaling. The interface blocks 245 may accordingly include circuitry configured to receive the second access command signaling from the respective interface block 220 and, in some examples, to access a respective set of one or more memory arrays 250 based on (e.g., in response to) the received second access command signaling. In various examples, the first access command signaling may include access commands that are associated with a type of operation (e.g., a read operation, a write operation, a refresh operation, a memory management operation), which may be associated with an indication of an address of the one or more memory arrays 250 (e.g., a logical address, a physical address). In some examples, the first access command signaling may include an indication of a logical address associated with the memory arrays 250, and circuitry of an interface block 220 may be configured to generate the second access command signaling to indicate a physical address associated with the memory arrays 250 (e.g., a row address, a column address, using a logical-to-physical (L2P) table or other mapping or calculation functionality of the interface block 220).

In some examples, to support write operations of the system 200, circuitry of the interface blocks 220 may be configured to receive (e.g., from a host processor 210, from a controller 215, via a host interface 216, via one or more contacts 212 from a host processor 210 or controller 215 external to a die 205) first data signaling associated with the first access command signaling, and to transmit second data signaling (e.g., associated with second access command signaling) based on received first access command signaling and first data signaling. The interface blocks 245 may accordingly be configured to receive second data signaling, and to write data to one or more memory arrays 250 (e.g., in accordance with an indicated address associated with the first access command signaling) based on the received second access command signaling and second data signaling. In some examples, the interface blocks 220 may include an error control functionality (e.g., error detection circuitry, error correction circuitry, error correction code (ECC) logic, an ECC engine) that supports the interface blocks 220 generating the second data signaling based on performing an error control operation using the received first data signaling (e.g., detecting or correcting an error in the first data signaling, determining one or more parity bits to be conveyed in the second data signaling and written with the data).

In some examples, to support read operations of the system 200, circuitry of the interface blocks 245 may be configured to read data from the memory arrays 250 based on received second access command signaling, and to transmit first data signaling based on the read data. The interface blocks 220 may accordingly be configured to receive first data signaling, and to transmit second data signaling (e.g., to a host processor 210, to a controller 215, via a host interface 216, via one or more contacts 212 to a host processor 210 or controller 215 external to a die 205) based on the received first data signaling. In some examples, the interface blocks 220 may include an error control functionality that supports the interface blocks 220 generating the second data signaling based on performing an error control operation using the received first data signaling (e.g., detecting or correcting an error in the first data signaling, which may include a calculation involving one or more parity bits received with the first data signaling).

In some examples, access command signaling that is transmitted by the interface blocks 220 to the interface blocks 245, among other signaling, may be generated (e.g., based on access command signaling received from a host processor 210, based on initiation signaling received from a host processor 210, without receiving or otherwise independent from signaling from a host processor 210) in accordance with various determination or generation techniques configured at the interface blocks 220 (e.g., based on a configuration for accessing memory arrays 250 that is modified at the interface blocks 220). In some examples, such techniques may involve signaling or other coordination with a logic block 230, a host processor 210, one or more controllers 215, one or more instances of non-volatile storage, one or more sensors, or any combination thereof. Such techniques may support the interface blocks 220 configuring aspects of the access operations performed on the memory arrays 250 by a respective interface block 245, among other operations. For example, interface blocks 220 may include evaluation circuitry, access configuration circuitry, signaling circuitry, scheduling circuitry, repair circuitry, refresh circuitry, error control circuitry, adverse access circuitry, and other circuitry operable to configure operations associated with one or more dies (e.g., operations associated with accessing memory arrays 250 of the dies 240).

In some cases, to manufacture a system 200, semiconductor wafers including dies 240 may be stacked and coupled together, and respective stacks of dies 240 may be individually separated (e.g., cut out) from the stack of semiconductor wafers (e.g., rather than selecting individual semiconductor dies for stacking and coupling). In some examples, a semiconductor wafer including dies 205 may also be stacked and coupled with the stack of semiconductor wafers, and respective stacks of dies 240 and a die 205 that form a system 200 may be individually separated from the stack of semiconductor wafers. In some other examples, a die 205 may be stacked and coupled with a stack of dies 240, such as after the stack of dies 240 is separated. Although wafers with a relatively high yield (e.g., of dies 240, of dies 205) may be selected for inclusion in a wafer stack, a non-perfect yield of dies in such wafers may be compounded in the stack of wafers such that a yield of a resulting stack of dies 240 separated from the wafer stack may be reduced. As a result, performance (e.g., latency, bandwidth, storage capacity) and yield of systems 200 may be adversely affected by such stacking.

In accordance with techniques described herein, the system 200 may be configured to support sparing techniques to improve yield of a stack of dies 240, and thus a yield of systems 200. For example, one or more dies 240 may be spare dies included in the stack of dies 240. A logic block 230 of the die 205 may support sparing one or more failed components of a die 240 (e.g., a bank, a pseudo-channel, a channel, a die 240 in its entirety) with one or more components of the one or more spare dies 240 (e.g., a spare bank, a spare-pseudo-channel, a spare channel, a spare die 240 in its entirety). For instance, the logic block 230 may remap accessing of the failed components using one or more interface blocks 220 to the components of the one or more spare dies 240 using one or more other interface blocks 220, such that accesses to an address space (e.g., an address space available to a host processor 210, a logical address space) corresponding to the failed components may instead access the one or more components of the one or more spare dies 240. Additionally, or alternatively, one or more dies 240 may include spare portions (e.g., one or more spare memory arrays 250) to which the logic block 230 may remap accessing of failed components (e.g., using different interface blocks 220). In some examples, such techniques may remap signaling of one or more host interfaces 216 from a respective first interface block 220, or portion thereof (e.g., subset of accessed components or addresses thereof), that is associated with a failed component to a second interface block 220, or portion thereof (e.g., subset of accessed components or addresses thereof), that is associated with a spare component (e.g., using a multiplexing or mapping component between host interfaces 216 and interface blocks 220, not shown), which may support such sparing techniques that are transparent to a host system 105.

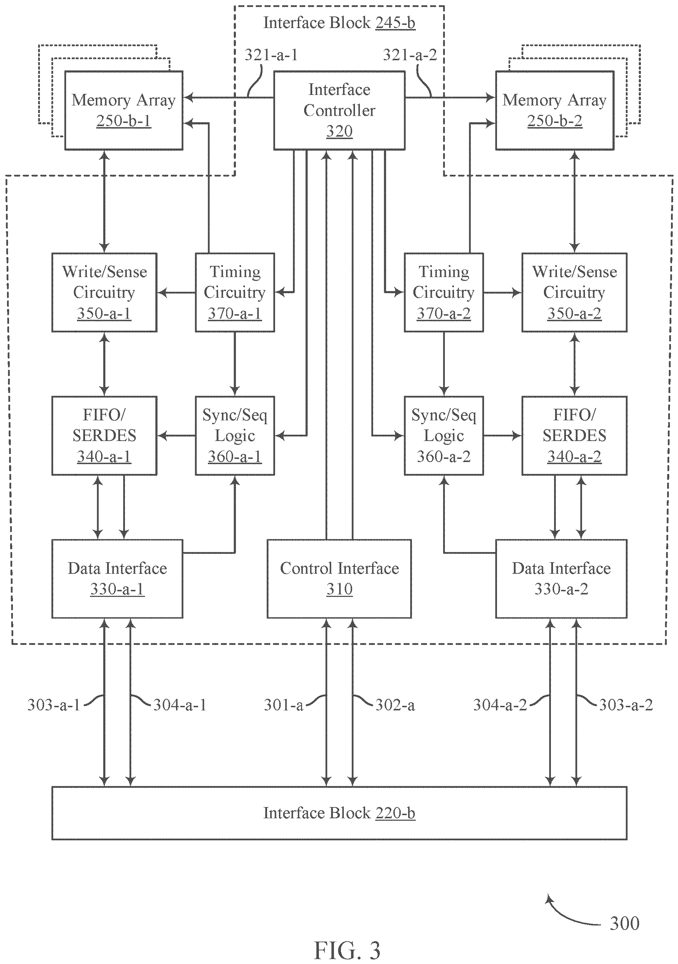

**FIG. 3** shows an example of an interface architecture 300 that supports sparing techniques in stacked memory architectures in accordance with examples as disclosed herein. The interface architecture 300 illustrates an example of an interface block 245-b (e.g., of a die 240) coupled with an interface block 220-b (e.g., of a die 205). The interface block 245-b may be communicatively coupled with the interface block 220-b via one or more of a bus 301, a bus 302, a bus 303, and a bus 304, each of which may be examples of one or more signal paths of a bus 221 and a bus 246, as well as a bus 255, where applicable.

The interface block 245-b includes a control interface 310 (e.g., a command interface), which may be configured to communicate signaling with the interface block 220-b. For example, the control interface 310 may include circuitry (e.g., a receiver, one or more latches) configured to receive control signaling (e.g., modulated control signaling, access command signaling, configuration signaling, address signaling, such as row address signaling or column address signaling) via the bus 301-a. The control interface 310 also may include circuitry configured to receive clock signaling (e.g., clock signaling associated with the control interface 310, clock signaling having one or more phases, such as true and complement phases, dk_t/c signaling from the interface block 220-b) via the bus 302-a, which the control interface 310 may use for receiving the control signaling of the bus 301-a (e.g., for triggering the one or more latches). The control interface 310 may transmit (e.g., forward) the control signaling the clock signaling (e.g., for timing of other operations of the interface block 245-b) to an interface controller 320.

The interface block 245-b also includes two data interfaces 330 (e.g., data interfaces 330-a-1 and 330-a-2), which also may be configured to communicate signaling with the interface block 220-b. Each data interface 330 may include corresponding buses and circuitry, the operation of which may be associated with (e.g., controlled by, coordinated with, operated based on) control signaling via the control interface 310. Although the example of interface block 245-b includes two such data interfaces 330 associated with the control interface 310 (e.g., in a "channel pair" arrangement), the described techniques for an interface block 245 may include any quantity of one or more data interfaces 330, and associated buses and circuitry, for a given control interface 310 of the interface block 245. Each data interface 330 may be associated with respective data path circuitry, which may include respective first-in-first-out (FIFO) and serialization/deserialization (SERDES) circuitry (e.g., FIFO/SERDES 340), respective write/sense circuitry 350, respective synchronization and sequencing circuitry (e.g., sync/seq logic 360), and respective timing circuitry 370, along with interconnecting signal paths (e.g., one or more buses). However, in some other examples, data path circuitry may be arranged in a different manner, or may include different circuitry components, which may include circuitry that is dedicated to respective data paths, or shared among data paths, or various combinations thereof. Each data interface 330 also may be associated with a respective set of one or more memory arrays 250. In some examples, each memory array 250 may be understood to include respective addressing circuitry such as bank logic or decoders (e.g., a row decoder, a column decoder), among other array circuitry. However, in some other examples, at least a portion of such circuitry may be included in an interface block 245.

Each data interface 330 may include circuitry (e.g., one or more latches, one or more drivers) configured to communicate (e.g., receive, transmit) data signaling (e.g., modulated data signaling, DQ signaling) via a respective bus 303. Each data interface 330 also may include circuitry to communicate clock signaling via a respective bus 304, which may support clock signal reception by the data interface 330 (e.g., first clock signaling associated with the data interface 330, clock signaling having one or more phases, such as true and complement phases, DQS_t/c signaling from the interface block 220-b, clock signaling associated with data reception or write operations), or clock signal transmission by the data interface 330 (e.g., second clock signaling associated with the data interface 330, RDQS_t/c signaling to the interface block 220-b, clock signaling associated with data transmission or read operations), or both. In some examples, a data interface 330, a bus 303, or a combination of a bus 303 and a bus 304, may be associated with a "pseudo-channel," and multiple pseudo-channels may be associated with a same control interface 310 or a same control bus (e.g., a bus 301, a combination of a bus 301 and a bus 302). Each data interface 330 may transmit clock signaling (e.g., received clock signaling, DQS_t/c signaling) to sync/seq logic 360 via a respective bus (e.g., for timing of other operations of the interface block 245-b).

The interface controller 320 may support various control or configuration functionality of the interface block 245-b for accessing or otherwise managing operations of the coupled memory arrays 250. For example, the interface controller 320 may support access command coordination or configuration, latency or timing compensation, access command buffering (e.g., in accordance with a FIFO or other organizational scheme), mode registers or logic for configuration settings, or test functionality, among other functions or combinations thereof. For each data path of the interface block 245 (e.g., associated with a respective data interface 330), the interface controller 320 may be configured to transmit signaling to the respective memory arrays 250 via a bus 321 (e.g., address signaling, such as a row address or row activation signaling). For each data path of the interface block 245, the interface controller 320 may communicate signaling (e.g., timing signaling, which may be based on clock signaling received from the control interface 310, configuration signaling) with respective timing circuitries 370 and sync/seq logic 360 via respective buses.

For each data path, the respective timing circuitry 370 may support timing of various operations (e.g., activations, coupling operations, signal latching, signal driving) relative to timing signaling received from the interface controller 320. For example, timing circuitry 370 may include a timing chain (e.g., a global column timing chain) configured to generate one or more clock signals or other initiation signals for controlling operations of the respective data path, and such signaling may include transitions (e.g., rising edge transitions, falling edge transitions, on/off transitions) that are offset from, at a different rate from, or otherwise different from transitions of signaling from the interface controller 320 to support a given operation or combination of operations. For example, timing circuitry 370 may be configured to transmit signaling (e.g., column selection signaling, column address signaling) to the respective memory arrays 250, to transmit signaling to the respective write/sense circuitry 350 (e.g., latch or driver timing signaling), and to transmit signaling to the respective sync/seq logic (e.g., timing signaling).

For each data path, the respective FIFO/SERDES 340 may be configured to convert between data signaling of a first bus width (e.g., a relatively wide bus width, a data read/write (DRW) bus, a bus for communications with write/sense circuitry 350 having a relatively larger quantity of signal paths) and a second bus width (e.g., a relatively narrow bus width, a bus for communications with a data interface 330 having a relatively smaller quantity of signal paths). In some examples, such a conversion may be accompanied by changing a rate of signaling between signaling from the data interface 330 and the write/sense circuitry 350 (e.g., to maintain a given throughput). In various examples, the FIFO/SERDES 340 may receive data signaling from the data interface 330 and transmit data signaling to the write/sense circuitry 350 (e.g., to support a write operation), or may receive data signaling from the sense circuitry 350 and transmit data signaling to the data interface 330 (e.g., to support a read operation). In some examples (e.g., to support a read operation), the FIFO/SERDES 340 may be configured to transmit clock signaling (e.g., RDQS_t/c signaling) to the data interface 330, which may be forwarded to the interface block 220-b.

The timing or other synchronization of operations performed by the FIFO/SERDES 340 may be supported by one or more clock signals, among other signaling, received from the respective sync/seq logic 360. For example, the sync/seq logic 360 may generate or otherwise coordinate clock signaling to support the different rates of signaling of different buses (e.g., based on received clock signaling). Additionally, or alternatively, the FIFO/SERDES 340 may operate in a direction (e.g., for data transmission to a data interface 330, for data reception from a data interface 330) or other mode based on configuration signaling received from the sync/seq logic 360.

For each data path, the respective write/sense circuitry 350 may be configured to support the accessing (e.g., data signaling, write signaling, read signaling) of the respective set of one or more memory arrays 250. For example, the write/sense circuitry 350 may be coupled with the memory arrays 250 via a bus (e.g., a global input/output (GIO) bus), which may include respective signal paths associated with each memory array 250, or may include signal paths that are shared for all of the memory arrays 250 of the set, in which case the memory array circuitry may include multiplexing circuitry operable to couple the bus with a selected one of the memory arrays 250. In some examples, a bus between the write/sense circuitry and the set of one or more memory arrays 250 may include a same quantity of signal paths as a bus between the write/sense circuitry 350 and the FIFO/SERDES 340 (e.g., for signaling GIO[287:0]) or a same quantity of signal paths as a quantity of columns in each memory array 250. In some other examples, the memory arrays 250 may include a quantity of columns that is an integer multiple of the quantity of signal paths of the bus, in which case the memory array circuitry (e.g., each memory array 250) may include decoding circuitry operable to couple a subset of columns of memory cells, or associated circuitry, with the bus.

To support write operations, the write/sense circuitry 350 may be configured to drive signaling that is operable to write one or more logic states to memory cells of the memory arrays 250 (e.g., based on received data, based on received timing signaling, based on data signaling received via a bus 303 and on control signaling received via a bus 301-a). In some examples, such signaling may be transmitted to supporting circuitry of or otherwise associated with the memory arrays 250 (e.g., as an output of signals corresponding to logic states to be written), such as sense amplifier circuitry, voltage sources, current sources, or other driver circuitry operable to apply a bias across a storage element of the memory cells (e.g., across a capacitor, across a ferroelectric capacitor), or apply a charge, a current, or other signaling to a storage element of the memory cells (e.g., to apply a current to a chalcogenide or other configurable memory material, to apply a charge to a gate of a NAND memory cell), among other examples.

To support read operations, the write/sense circuitry 350 may be configured to receive signaling that the write/sense circuitry 350 may further amplify for communication through the interface block 245-b. For example, the write/sense circuitry 350 may be configured to receive signaling corresponding to logic states read from the memory arrays 250, but at a relatively low driver strength (e.g., relatively 'analog' signaling, which may be associated with a relatively low drive strength of sense amplifiers of the memory arrays 250). The write/sense circuitry 350 may thus include further sense amplification (e.g., a data sense amplifier (DSA) between signal paths between the write/sense circuitry and the set of one or more memory arrays and respective signal paths between the write/sense circuitry and the FIFO/SERDES), which each may have a relatively high drive strength (e.g., for driving relatively 'digital' signaling).

The features of the interface architecture 300 may be duplicated in various quantities and arrangements to support a semiconductor system having multiple dies, such as various examples of a system 200. In an example implementation, each die 240 may be configured with 64 instances of the interface block 245-b, which may support a data signaling width of 9,216 signal paths for each die 240 (e.g., where each bus 303 of a channel pair is associated with 72 signal paths). For a system 200 having a stack of eight dies 240 coupled with a die 205, the die 205 may thus be configured with 512 instances of the interface block 220-b, thereby supporting an overall data signaling width of 73,738 signal paths for the system 200. However, in other implementations, dies 205 and dies 240 may be configured with different quantities of interface blocks 220 and 245, respectively, and a system 200 may be configured with different quantities of dies 240 per die 205.

In accordance with techniques described herein, a system that implements the interface architecture 300 (e.g., a system 200) may support sparing techniques to improve yield of a stack of dies 240, and thus a yield of related stacked semiconductor systems. For example, one or more dies 240 may be spare dies included in the stack of dies 240. A logic block 230 of the die 205 may support sparing one or more failed components (e.g., a bank, a pseudo-channel, a channel, a die 240) of the dies 240 with one or more components (e.g., a bank, a pseudo-channel, a channel, a die 240) of the one or more spare dies 240. For instance, the logic block 230 may remap accessing of the failed components using one or more interface blocks 220 to the components of the one or more spare dies 240 using one or more other interface blocks 220 such that accesses to an address space (e.g., available to a host processor 210) corresponding to the failed components may instead access the one or more components of the one or more spare dies 240. Additionally, or alternatively, one or more dies 240 may include spare portions (e.g., one or more spare memory arrays 250) to which the logic block 230 may remap accessing of failed components (e.g., using different interface blocks 220).

In some examples, sparing techniques may include a remapping of at least a portion of interface blocks 220-b, or interface blocks 245-b, or both for a given host interface 216 (e.g., isolating an interface block 220-b associated with a component failure from a host interface 216 and coupling an interface block 220-b associated with a spare component with the respective host interface 216). To support die-level sparing, for example, a logic block 230 may remap (e.g., for respective host interfaces 216) each instance of an interface block 245-b in a first die 240 (e.g., and corresponding interface block 220-b) to a respective instance of an interface block 245-b in a second die 240 (e.g., and corresponding interface block 220-b). To support channel-level sparing, the logic block 230 may remap a first instance of an interface block 245-b (e.g., in a first die 240) and corresponding interface block 220-b to a second instance of an interface block 245-b (e.g., in the first die 240, in a second die 240) and corresponding interface block 220-b. To support pseudo-channel level sparing, the logic block 230 may remap a first pseudo-channel (e.g., a bus 303-a and a bus 304-a, a data channel) associated with a first instance of an interface block 245-b (e.g., in a first die 240) and, in some examples, a first instance of an interface block 220-b to a second pseudo-channel associated with a second instance of an interface block 245-b (e.g., in the first die 240, in a second die 240) and, in some examples, a second instance of an interface block 220-b. To support bank-level sparing, the logic block 230 may remap a first bank (e.g., a memory array 250-b, a bank of a memory array 250-b) associated with a first instance of an interface block 245-b (e.g., in a first die 240) and, in some examples, a first instance of an interface block 220-b to a second bank associated with a second instance of an interface block 245-b (e.g., in the first die 240, in a second die 240) and, in some examples, a second instance of an interface block 220-b.

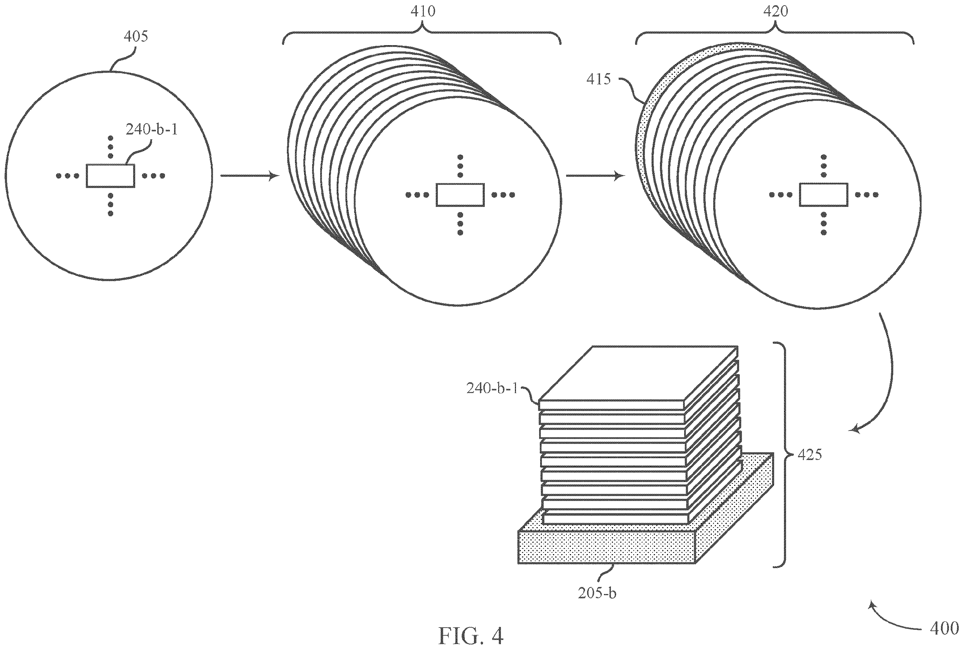

**FIG. 4** shows an example of a manufacturing process 400 that supports sparing techniques in stacked memory architectures in accordance with examples as disclosed herein. For example, FIG. 4 may illustrate aspects of a sequence of manufacturing operations for fabricating a stack 425 (e.g., a stack of dies), which may be an example of at least a portion of a system 200. Operations illustrated in and described with reference to FIG. 4 may be performed by a manufacturing system, such as a semiconductor fabrication system configured to perform additive operations such as deposition or bonding, subtractive operations such as etching, trenching, planarizing, or polishing, and supporting operations such as masking, patterning, photolithography, coupling, stacking, cutting, or aligning, among other operations that support the described techniques. In some examples, operations performed by such a manufacturing system may be supported by a process controller or its components as described herein.

A first set of one or more manufacturing operations may include the formation of dies 240-b on a wafer 405. For example, the wafer 405 may be a semiconductor wafer on which a set of dies 240-b are formed, such as via various additive operations, subtractive operations, supporting operations, doping operations, or a combination thereof, among other types of operations.

To manufacture a system 200, such as a TCDRAM system, coupling (e.g., bonding) of dies 240-b in a stack may occur at the wafer level. For example, a second set of one or more manufacturing operations may include the coupling of a set of wafers 405 into a stack 410 (e.g., a stack of wafers). In some examples, coupling the wafers 405 may include fusing (e.g., bonding) respective conductive materials of respective contacts (e.g., contacts 247, contacts 256, contacts 257, contacts 260) of dies 240-b. As such, the stack 410 may include multiple stacks of dies 240-b that are stacked along a direction (e.g., a direction along which the wafers 405 are stacked).

In some examples, a third set of one or more manufacturing operations may include coupling a wafer 415 with the stack 410 to form a stack 420 (e.g., a stack of wafers). The wafer 415 may be a semiconductor wafer on which a set of dies 205-b are formed, such as via various additive operations, subtractive operations, supporting operations, doping operations, or a combination thereof, among other types of operations. The third set of manufacturing operations may include fusing (e.g., bonding) respective conductive materials of respective contacts (e.g., contacts 222) of the set of dies 205-b with respective conductive materials of respective contacts (e.g., contacts 247, contacts 256) of the dies 240-b. For example, respective contacts 222 of the set of dies 205-b may be coupled (e.g., fused, bonded) with contacts of a respective bottom die 240-b of each stack of dies 240-b while the set of dies 205-b are included in (e.g., a part of) the wafer 415 and the stacks of dies 240-b are included in (e.g., a part of) the wafers 405.

In some examples, a fourth set of one or more manufacturing operations may include separating a stack 425 from the stack 420. For example, the fourth set of one or more manufacturing operations may include cutting respective stacks 425 from the stack 420, where each stack 425 includes a respective die 205-b of the wafer 415 and a respective stack of dies 240-b coupled with the respective die 205-b. Each stack 425 may be an example of a respective system 200.

In some examples, the coupling of a die 205-b with a stack of dies 240-b to form the stack 425 may occur after the stack of dies 240-b are separated from the stack 410. For example, the third set of one or more manufacturing operations may include cutting respective stacks of dies 240-b from the stack 410. The fourth set of one or more manufacturing operations may include separating (e.g., cutting) a respective die 205-b from the wafer 415 and coupling the respective die 205-b with a respective stack of dies 240-b to form a respective stack 425. Although some techniques are described in the context of wafer stacking, the sparing techniques described herein may be implemented in stacks 425 formed by other techniques, such as those that involve directly stacking dies 240 and 205 (e.g., after one or more dies 240 or 205 are separated individually from one or more wafers).

The manufacturing of stacks 425 may be configured support sparing techniques as described herein. For example, a set of wafers 405 that are coupled together to form a stack 410 may include one or more additional (e.g., spare) wafers 405 such that each stack of dies 240-b that are separated from the stack 410 and included in a respective stack 425 may include one or more additional (e.g., spare) dies 240-b. For example, a stack 425 may include a die 240-b-1, which may be an example of a spare array die including components (e.g., banks, channels, pseudo-channels, the die 240-b-1 in its entirety) to which accessing may be remapped. In some examples, one or more dies 240-b may additionally, or alternatively, include additional (e.g., spare) portions including spare components (e.g., banks, channels, pseudo-channels, memory arrays) to which accessing may be remapped.

In some implementations, one or more functions of each die 240-b may be evaluated at various stages of the manufacturing process 400 to determine whether to perform sparing associated with the die 240-b. In some examples, a function of each die 240-b may be evaluated (e.g., by a manufacturing system, by a tester) before the stack 410 is formed. For instance, coupling the set of wafers 405 to form the stack 410 may occur after the function of each die 240-b of each wafer 405 has been evaluated. Additionally, or alternatively, a function of each die 240-b may be evaluated after the stack 410 is formed (e.g., before the stack 420 is formed, before a die 205-b is coupled with a respective stack 425). For example, a set of wafers 405 may be coupled together to form a stack 410 after which the function of each die 240-b may be evaluated. In some examples, a function of each die 240-b may be evaluated after a respective stack of dies 240-b is separated from a stack 410 and before a respective die 205-b is coupled with the respective stack of dies 240-b. Additionally, or alternatively, a function of each die 240-b may be evaluated after a stack 425 is formed. For example, a stack of dies 240-b may be coupled with a die 205-b, including as part of a stack 420 or as part of a stack 425, and a function of each die 240-b of the stack of dies 240-b may be evaluated, for example, using circuitry of a die 205-b (e.g., interface blocks 220 of the die 205-b).

Evaluating the function of each die 240-b may support the detection of one or more errors associated with a given die 240-b to determine whether to perform sparing for the die 240-b. For example, evaluating the function of a die 240-b may include performing one or more operations (e.g., access operations) to determine whether components of the die 240-b (e.g., of interface blocks 245, of memory arrays 250, of buses 251, of buses 255, of buses 246, of contacts or couplings thereof) are functioning properly and whether an error (e.g., failure) associated with a given component exists. In some examples, evaluating the function of a die 240-b may be relatively more granular after a stack 425 is formed. For example, circuitry of interface blocks 220 of a die 205-b of a stack 425 may be used to evaluate respective functions of dies 240-b of the stack 425 at a finer granularity than circuitry of a tester used to evaluate the respective functions before the formation of the stack 425. As such, in some cases, relatively more types of errors may be detected as part of an evaluation after the formation of a stack 425 than as part of an evaluation before the formation of the stack 425.

In some examples, an error associated with a die 240-b may be detected during operation of a stack 425 (e.g., during evaluation operations, during operations in an assembled or integrated condition, in a deployment of a stack 425). For example, errors may occur over time due to wear out or adverse operation (e.g., over-voltage operations, over-temperature operations), among other factors. In some examples, an error may occur as part of an attempted access of a memory array 250 of a die 240-b using an interface block 220 of a die 205-b. In some examples, the error may be detected by the interface block 220 based on a failure of the attempted access. In some examples, the interface block 220 may indicate (e.g., transmit an indication of) the error to a logic block 230 of the die 205-b.

In some examples, non-volatile storage of one or more dies 240-b or of a die 205-b may be set to indicate the error, and a logic block 230 may detect (e.g., identify) the error for the purposes of sparing based on accessing the non-volatile storage. For example, non-volatile storage 270 of a first die 240-b at which an error occurs may be set to indicate the error. Additionally, or alternatively, non-volatile storage 270 of a second die 240-b to which accessing is remapped may be set to indicate the error associated with the first die 240-b. Additionally, or alternatively, non-volatile storage 235 of a die 205-b may be set to indicate the error associated with first die 240-b (e.g., and to indicate the second die 240-b to which accessing is remapped). In some examples, to set a non-volatile storage 270 or non-volatile storage 235, one-time programmable storage elements of the non-volatile storage may be set. For example, one or more fuses or antifuses of the non-volatile storage may be set (e.g., blown) to indicate the error. In some cases, a tester performing the evaluation of a die 240-b may set a non-volatile storage 270 of the die 240-b. In some cases, circuitry of a logic die 205-b (e.g., an interface block 220, a logic block 230) may set (e.g., cause the setting of) a non-volatile storage 270 of a die 240-b or a non-volatile storage 235 of the logic die 205-b.

Sparing may be performed based on the detection (e.g., identification) of an error associated with a die 240-b. For example, a logic block 230 of a die 205-b may remap accessing (e.g., via one or more host interfaces 216) of a stack of dies 240-b based on (e.g., in response to) detecting the error, such as by accessing non-volatile storage 270 or 235 or based on a failed attempted access of one or more memory arrays 250 of the stack of dies 240-b. A logic block 230 may support remapping accessing of the stack of dies 240-b according to various levels of granularity, such as based on a type of the detected error. For example, a logic block 230 may support remapping at a die level of granularity, the channel level of granularity, a pseudo-channel level of granularity, a bank level of granularity, or a combination thereof.

By supporting sparing based on error detection, the yield of stacks 425 (e.g., systems 200, TCDRAM systems) may be increased, for example, by supporting the replacement of failed components with spare components. As such, performance of stacks 425, including bandwidth, storage capacity, latency, may be improved. Additionally, a time-to-market of products that implement the stack 425. For example, products released to the market may be associated with yield constraints, and improving yield via the sparing techniques described herein may enable such constraints to be satisfied without improving manufacturing techniques to increase the yield of individual semiconductor wafers, which may involve a delay before such improvements are realized. Additionally, the sparing techniques described herein may reduce costs as a final yield of a stack of dies 240-b may be unknown until after it is coupled with a die 205-b (e.g., due to finer granularity at which the function of the dies 240-b may be tested after coupling with the die 205-b). Accordingly, if a yield fails to meet yield constraints, the entire stack 425 may be discarded. Thus, improving yield of stacks of dies 240-b using the sparing techniques described herein may increase the likelihood that yield constraints are met, thereby reducing costs of manufacturing stacks 425.

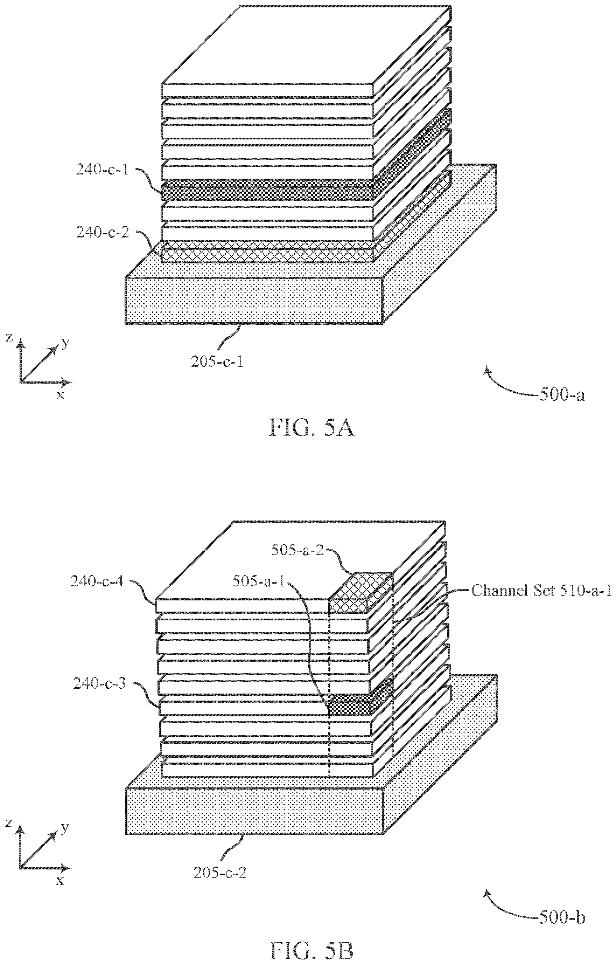

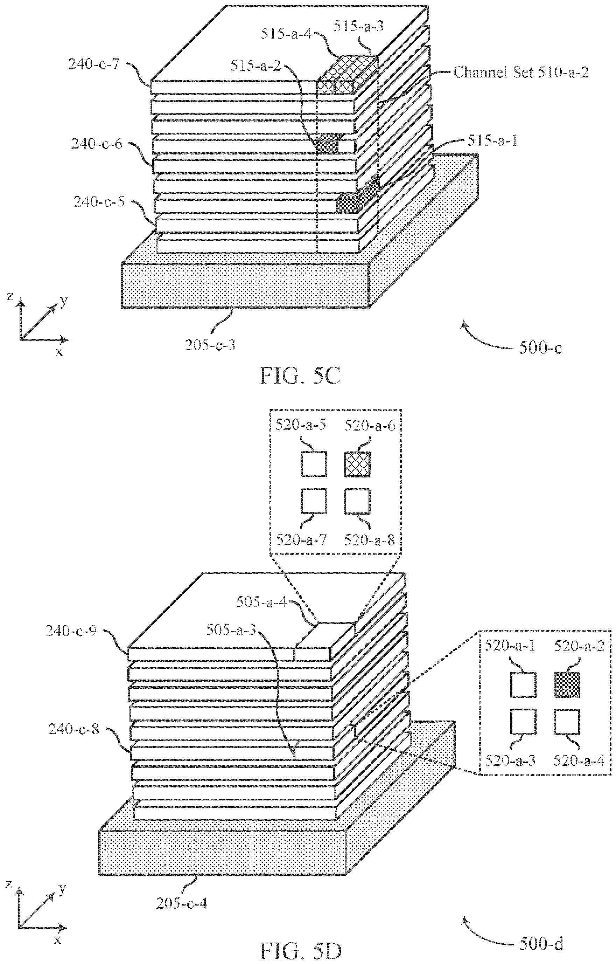

**FIGs. 5A, 5B****,** **5C, and 5D** show examples of sparing diagrams 500 that support sparing techniques in stacked memory architectures in accordance with examples as disclosed herein. The sparing diagrams 500 illustrate examples of remapping operations that may be performed to support sparing within a stack 425 (e.g., a system 200, a TCDRAM system) in accordance with various levels of granularity.

**FIG. 5A** shows a sparing diagram 500-a that supports die-level sparing. For example, the sparing diagram 500-a depicts a die 205-c-1 coupled with a set of dies 240-c stacked along a direction (e.g., a z-direction, a direction perpendicular to the die 205-c-1), which may collectively be an example of a stack 425. An error associated with a die 240-c-1 of the set of dies 240-c may be detected as described herein. Based on the detection of the error, a logic block 230 of the die 205-c-1 may remap access of the die 240-c-1 to a die 240-c-2 of the set of dies 240-c. For example, an address space available to (e.g., accessible by) a host system (e.g., a host system 105, a host processor 210, such as of the die 205-c-1 or included in another die coupled with the die 205-c-1) via a set of host interfaces 216 of the die 205-c-1 may include a portion of addresses that may be used by the host system to access the die 240-c-1 (e.g., memory arrays 250 of the die 240-c-1). The logic block 230 may remap the portion of addresses such that use of addresses within the portion by the host system (e.g., via a subset of host interfaces 216 of the die 205-c-1) may instead access the die 240-c-2 (e.g., memory arrays 250 of the die 240-c-2). In some examples, the die 240-c-2 may be a spare die of the set of dies 240-c.

The die 240-c-1 may include interface blocks 245 via which the memory arrays 250 of the die 240-c-1 may be accessed. To support remapping at the die level of granularity (e.g., the entirety of the portion of the address space corresponding to the die 240-c-1), the logic block 230 may remap access (e.g., via the subset of host interfaces 216 that correspond to the die 240-c-1) from all of the interface blocks 245 of the die 240-c-1 to respective interface blocks 245 of the die 240-c-2. For example, the portion of the address space corresponding to the die 240-c-1 may be remapped to the interface blocks 245 of the die 240-c-2. In some examples, a first set of interface blocks 220 of the die 205-c-1 may be coupled with the interface blocks 245 of the die 240-c-1. To support the remapping, the logic block 230 may remap access (e.g., remap coupling with the subset of host interfaces 216) from the first set of interface blocks 220 to a second set of interface blocks 220 of the die 205-c-1 that are coupled with the interface blocks 245 of the die 240-c-2. For example, the portion of the address space corresponding to the die 240-c-1 may be remapped to the second set of interface blocks 220 such that accesses of addresses within the remapped portion of the address space may be supported by respective interface blocks 220 of the second set of interface blocks 220. In some examples, the second set of interface blocks 220 may be referred to as spare interface blocks 220 of the die 205-c-1 (e.g., based on being coupled with interface blocks 245 of a spare die 240-c).

In some examples, one or more spare dies 240 (e.g., for die-level sparing, for channel-level, sparing, for pseudo-channel-level sparing, for bank-level sparing) in accordance with the described techniques may be located at various positions (e.g., stack positions, positions along the z-direction) in a stack 425 to support various operating characteristics of the system. For example, one or more spare dies 240 may be located at the bottom of a stack 425 (e.g., spare dies 240 of a stack 425 that are located nearest to the die 205 along the z-direction, such as die 240-c-2 being adjacent to die 205-c-1, one or more spare dies 240 that are between a die 205 and one or more dies 240 allocated to nominal or initial operations). In some examples, positioning one or more spare dies 240 at the bottom of a stack 425 may provide thermal benefits to the system. For example, dies 240-c located relatively nearer to the die 205-c-1 along the z-direction may be relatively hotter than dies 240-c located further from the die 205-c-1, which may be due to a relatively high power density associated with the die 205-c-1, or having an otherwise unfavorable thermal path for heat rejection, among other considerations. In some cases, relatively higher temperatures may be associated with a relatively higher likelihood of errors or otherwise degraded performance of a die 240. Accordingly, by positioning a spare die 240 relatively nearer to a die 205, adverse thermal characteristics of the spare die 205 may be avoided in nominal (e.g., initial, as-built) configurations, and may be implicated or addressed if the spare die 240, or some portion thereof, is implemented (e.g., by a logic block 230). Further, dies 240 of a stack 425 that are configured for nominal operations may be relatively cooler than one or more spare dies by positioning them relatively farther from a die 205, thereby improving nominal performance of the system (e.g., improving performance of the dies 240 for nominal operations), reducing a likelihood of errors that may involve resolution by way of sparing, or both.

In some other examples, a spare die 240 may be located at another position within a stack 425. For example, a spare die 240 may be located at the top of a stack 425 (e.g., above other dies 240-c along the z-direction). In some examples, such an implementation may be associated with relatively shorter or otherwise less-complex electrical routing (e.g., a shorter distance along the z-direction, fewer interconnections between dies), which may be associated with relatively favorable signaling characteristics in a nominal configuration, or a relatively higher nominal yield (e.g., due to relatively fewer die-to-die connections implicated for the nominal configuration, and a reduced likelihood of requiring sparing). In some other examples, locations of spare dies 240 may not be pre-determined, and spare dies 240 may allocated at various positions based on evaluations of the dies 240 themselves, or evaluations of the dies 240 after stacking, or various combinations thereof.

**FIG. 5B** shows an example of a sparing diagram 500-b that supports channel-level sparing. For example, the sparing diagram 500-b depicts a die 205-c-2 coupled with a set of dies 240-c stacked along a direction (e.g., a z-direction), which may be an example of a stack 425. An error associated with a die 240-c-3 of the set of dies 240-c may be detected as described herein. For example, each die 240-c may include a set of channels 505-a (e.g., 64 channels, associated with 64 units 265) via which information may be communicated between an interface block 220 of the die 205-c-2 and an interface block 245 of the die 240-c. For instance, each channel 505-a may include a command channel (e.g., a bus 301 and a bus 302) and a set of data channels (e.g., each data channel including a bus 303 and a bus 304) via which the interface block 220 and the interface block 245 may communicate signaling. In some examples, each channel 505-a may include one command channel and two data channels (e.g., a channel pair, two pseudo-channels). In some examples, groups of channels 505-a within the stacked dies 240-c may be arranged (e.g., organized) according to channel sets 510-a. For example, a channel set 510-a may include a respective channel 505-a for each unit 265 across the set of dies 240-c, for which signaling may be passed through buses 255 of units 265 that are stacked along the z-direction. In some examples, an interface block 220 of the die 205-c-2 may be associated with a respective channel 505-a, or a channel set 510-a. For example, the die 205-c-2 may include a respective interface block 220 for each channel 505-a of the set of dies 240-c.

In the example of FIG. 5B, an error associated with a channel 505-a-1 of the die 240-c-3 may be detected. Based on the detection of the error, a logic block 230 of the die 205-c-2 may remap access of the channel 505-a-1 (e.g., of a unit 265 corresponding to the channel 505-a-1) to another channel 505-a of the set of dies 240-c (e.g., to another unit 265). For example, the logic block 230 may remap access of the channel 505-a-1 to a channel 505-a-2 of a die 240-c-4 of the set of dies 240-c, which may be included in a channel set 510-a-1 that includes the channels 505-a-1 and 505-a-2. In some other examples, the logic block 230 may remap access of the channel 505-a-1 to another channel 505-a of the die 240-c-4 that is not included in the channel set 510-a-1 (e.g., included in another channel set 510-a). In some other examples, the die 240-c-3 may include one or more spare channels 505-a, and the logic block 230 may remap access of the channel 505-a-1 to a spare channel 505-a of the die 240-c-3. In some examples, the die 240-c-4 may be a spare die of the set of dies 240-c, and the channels 505-a of the die 240-c-4 may be spare channels 505-a.

To support the remapping, the logic block 230 may remap a portion of an address space available to a host system that corresponds to the channel 505-a-1. For example, the logic block 230 may remap the portion of addresses such that use of addresses within the portion by the host system may instead access the channel 505-a-2 (e.g., memory arrays 250 of a unit 265 accessible via the channel 505-a-2) or some other channel 505-a to which the logic block 230 remaps access of the channel 505-a-1. To remap the portion of the address space, the logic block 230 may remap an interface block 245 of the die 240-c-3 associated with the channel 505-a-1 to an interface block 245 of the die 240-c-4 associated with the channel 505-a-2 or to an interface block 245 associated with some other channel 505-a to which access of the channel 505-a-1 is remapped (e.g., another interface block 245 of the die 240-c-3 associated with a spare channel 505-a of the die 240-c-3).

Additionally, or alternatively, the logic block 230 may remap access from a first interface block 220 of the die 205-c-2 associated with the channel 505-a-1 to a second interface block 220 of the die 205-c-2 associated with the channel 505-a-2 or some other channel 505-a to which access of the channel 505-a-1 is remapped. For example, the portion of the address space corresponding to the channel 505-a-1 may be remapped to the second interface block 220 such that accesses of addresses within the remapped portion of the address space may be supported by the second interface block 220. In some examples, the second interface block 220 may be referred to as a spare interface block 220 (e.g., based on being coupled with an interface block 245 associated with a spare channel 505-a).

In some examples, a die 240 that includes a channel 505 to which a portion of an address space is remapped (e.g., a channel 505 of a spare die 240) may be located at various positions within a stack 425. In some cases, a spare die 240 may be located at a bottom of the stack 425, which may provide thermal benefits to other dies 240 of the stack 425. For example, dies 240-c located nearer to the die 205-c-2 along the z-direction may be relatively hotter than dies 240-c located further from the die 205-c-2 due to a high power density associated with the die 205-c-2. By positioning a spare die 240-c nearer to the die 205-c-2, other dies 240-c of the stack 425 may be relatively cooler, thereby improving performance of a nominal configuration, or decreasing the likelihood of errors that may result in the logic block 230 performing the remapping, or both.

**FIG. 5C** shows an example of a sparing diagram 500-b that supports pseudo-channel-level sparing. For example, the sparing diagram 500-c depicts a die 205-c-3 coupled with a set of dies 240-c stacked along a direction (e.g., a z-direction), which may be an example of a stack 425. An error associated with one or more dies 240-c of the set of dies 240-c may be detected as described herein. For example, each die 240-c may include a set of channels 505-a that each include a command channel (e.g., a bus 301-a and a bus 302-a) and a set of data channels (e.g., each data channel including a bus 303-a and a bus 304-a) via which a respective interface block 220 and interface block 245 may communicate signaling. Each channel 505-a may include a set of pseudo-channels 515, each of which may be associated with a respective data interface 330. For example, a command channel of a channel 505-a (e.g., associated with a control interface 310) may be shared by (e.g., common to) the data channels of the channel 505-a. That is, command signaling associated with communicating data via each of the data channels of the channel 505-a may be communicated via the shared command channel. A pseudo-channel 515 may include a respective data channel of a channel 505-a and the shared command channel. In the example of FIG. 5C, each channel 505-a may include one command channel and two data channels and may thus include two pseudo-channels 515. In some examples, the die 205-c-3 may include a respective interface block 220 for each channel 505-a of the set of dies 240-c. Accordingly, each interface block 220 may be for (e.g., communicate signaling via) a set of pseudo-channels 515 included in a corresponding channel 505-a.

In the example of FIG. 5C, one or more errors associated with one or more pseudo-channels 515 may be detected. For example, an error associated with a pseudo-channel 515-a-1 of a die 240-c-5 of the set of dies 240-c may be detected, or an error associated with a pseudo-channel 515-a-2 of a die 240-c-6 of the set of dies 240-c may be detected, or both. Based on the detection of the one or more errors, a logic block 230 of the die 205-c-3 may remap access of the pseudo-channels 515-a-1 or 515-a-2 to other pseudo-channels 515-a of the set of dies 240-c. For example, the logic block 230 may remap access of the pseudo-channel 515-a-1 to a pseudo-channel 515-a-3 of a die 240-c-7 of the set of dies 240-c, or remap access of the pseudo-channel 515-a-2 to a pseudo-channel 515-a-4 of the die 240-c-7, or both. In some examples, the pseudo-channels 515-a to which the accessing is remapped may be included in a same channel set 510-a (e.g., a channel set 510-a-2) that includes the pseudo-channels 515-a-1 and 515-a-2. In some other examples, the logic block 230 may remap access of the pseudo-channels 515-a-1 and pseudo-channels 515-a-2 to other pseudo-channels 515-a of the die 240-c-7 that are not included in the channel set 510-a-2 (e.g., included in another channel set 510-a). In some other examples, in some cases, the dies 240-c-5 and/or 240-c-6 may include one or more spare channels 505-a, and the logic block 230 may remap access of the pseudo-channels 515-a-1 and pseudo-channels 515-a-2 to other pseudo-channels 515-a of the dies 240-c-5 and 240-c-6, respectively (e.g., spare pseudo-channels 515-a included in a spare channel 505-a). In some examples, the die 240-c-7 may be a spare die of the set of dies 240-c, and the pseudo-channels 515-a of the die 240-c-7 may be spare pseudo-channels 515-a.

In some examples, remapping access from the pseudo-channels 515-a-1 and 515-a-2 may include remapping access from the corresponding data channels of the pseudo-channels 515-a-1 and 515-a-2 to the data channels of the pseudo-channels 515-a to which the pseudo-channels 515-a-1 and 515-a-2 are remapped (e.g., pseudo-channels 515-a-3 and 515-a-4).

To support the remapping, the logic block 230 may remap a portion of an address space available to a host system that corresponds to the pseudo-channels 515-a-1 and 515-a-2. For example, the logic block 230 may remap the portion of addresses such that use of addresses within the portion by the host system may instead access the pseudo-channels 515-a-3 and 515-a-4, respectively (e.g., memory arrays 250 accessible via the pseudo-channels 515-a-3 and 515-a-4) or some other pseudo-channels 515-a to which the logic block 230 remaps access of the pseudo-channels 515-a-1 and 515-a-2. Due to pseudo-channels 515-a sharing a command channel with at least one other pseudo-channel 515-a, in some examples, the communication of shared command signaling via remapped pseudo-channels 515-a may be coordinated. For example, the logic block 230 may configure a first interface block 220 associated with the pseudo-channel 515-a-1 and/or a second interface block 220 associated with the pseudo-channel 515-a-3 to communicate shared command signaling via a command channel of a first channel 505-a that includes the pseudo-channel 515-a-1 and a command channel of a second channel 505-a that includes the pseudo-channel 515-a-3. For example, command signaling may continue to be communicated via the command channel of the first channel 505-a using the first interface block 220 in association with communicating data via another pseudo-channel 515-a of the first channel 505-a, and command signaling associated with the communication of data via the pseudo-channel 515-a-1 may instead be communicated via the command channel of the second channel 505-a using the second interface block 220. The logic block 230 may similarly configure a third interface block 220 associated with the pseudo-channel 515-a-2 and/or the second interface block 220 associated with the pseudo-channel 515-a-4 to communicate shared command signaling via a command channel of a channel 505-a that includes the pseudo-channel 515-a-2 and a command channel of a channel 505-a that includes the pseudo-channel 515-a-4.

In some examples, a die 240 that includes a pseudo-channel 515 to which a portion of an address space is remapped (e.g., a pseudo-channel of a spare die 240) may be located at various positions within a stack 425. In some cases, a spare die 240 may be located at a bottom of the stack 425, which may provide thermal benefits to other dies 240 of the stack 425. For example, dies 240-c located nearer to the die 205-c-3 along the z-direction may be relatively hotter than dies 240-c located further from the die 205-c-3 due to a high power density associated with the die 205-c-3. By positioning a spare die 240-c nearer to the die 205-c-3, other dies 240-c of the stack 425 may be relatively cooler, thereby improving performance of a nominal configuration, or decreasing the likelihood of errors that may result in the logic block 230 performing the remapping, or both.

**FIG. 5D** shows an example of a sparing diagram 500-b that supports bank-level sparing. For example, the sparing diagram 500-d depicts a die 205-c-4 coupled with a set of dies 240-c stacked along a direction (e.g., a z-direction), which may be an example of a stack 425. An error associated with a die 240-c-8 of the set of dies 240-c may be detected as described herein. For example, each die 240-c may include one or more channels 505-a via which one or more memory arrays 250 of the die 240-c may be accessed. In some examples, a memory array 250 may include one more banks 520-a, which may be banks of memory cells. In some examples, a memory array 250, or a portion thereof, may be an example of a bank 520-a. In the example of FIG. 5D, the die 240-c-8 may include a channel 505-a-3 via which one or more banks 520-a may be accessed. For example, the channel 505-a-3 may be used to access banks 520-a-1, 520-a-2, 520-a-3, and 520-a-4. In the example of FIG. 5D, an error associated with the bank 520-a-2 may be detected.

Based on the detection of the error, a logic block 230 of the die 205-c-4 may remap access of the bank 520-a-2 to another bank 520-a of the set of dies 240-c. For example, an address space available to a host system may include a portion of addresses that may be used by the host system to access the bank 520-a-2. The logic block 230 may remap the portion of addresses such that use of addresses within the portion by the host system may instead access another bank 520-a, which may be referred to as a spare bank 520-a. For example, a die 240-c-9 of the set of dies 240-c may include a channel 505-a-4 (e.g., included in a same channel set 510-a that includes the channel 505-a-3) that supports accessing banks 520-a-5, 520-a-6, 520-a-7, and 520-a-8. The logic block 230 may remap accessing from the bank 520-a-2 to the bank 520-a-6 or some other bank 520-a of the channel 505-a-4 or the die 240-c-9. Additionally, or alternatively, the die 240-c-8 may include one or more spare banks 520 (e.g., associated with one or more spare channels 505-a), and the logic block 230 may remap access of the bank 520-a-2 to a spare bank 520-a of the die 240-c-8. In some examples, the die 240-c-9 may be a spare die of the set of dies 240-c, and the banks 520-a of the die 240-c-9 may be spare banks 520-a.

To support remapping the portion of the address space, the logic block 230 may remap accessing of the bank 520-a-2 from a first interface block 220 of the die 205-c-4 associated with the channel 505-a-3 to a second interface block 220 of the die 205-c-4 associated with the channel 505-a-4 that includes the bank 520-a-6 or some other channel 505-a that includes the bank 520-a to which access of the bank 520-a-2 is remapped. For example, the portion of the address space corresponding to the bank 520-a-2 may be remapped to the second interface block 220 such that accesses of addresses within the remapped portion of the address space may be supported by the second interface block 220. In some examples, the second interface block 220 may be referred to as a spare interface block 220 (e.g., based on being coupled with an interface block 245 associated with a spare channel 505-a).

In some examples, a die 240 that includes a bank 520 to which a portion of an address space is remapped (e.g., a bank 520 of a spare die 240) may be located at various positions within a stack 425. In some cases, a spare die 240 may be located at a bottom of the stack 425, which may provide thermal benefits to other dies 240 of the stack 425. For example, dies 240-c located nearer to the die 205-c-4 along the z-direction may be relatively hotter than dies 240-c located further from the die 205-c-4 due to a high power density associated with the die 205-c-4. By positioning a spare die 240-c nearer to the die 205-c-4, other dies 240-c of the stack 425 may be relatively cooler, thereby improving performance of a nominal configuration, or decreasing the likelihood of errors that may result in the logic block 230 performing the remapping, or both.

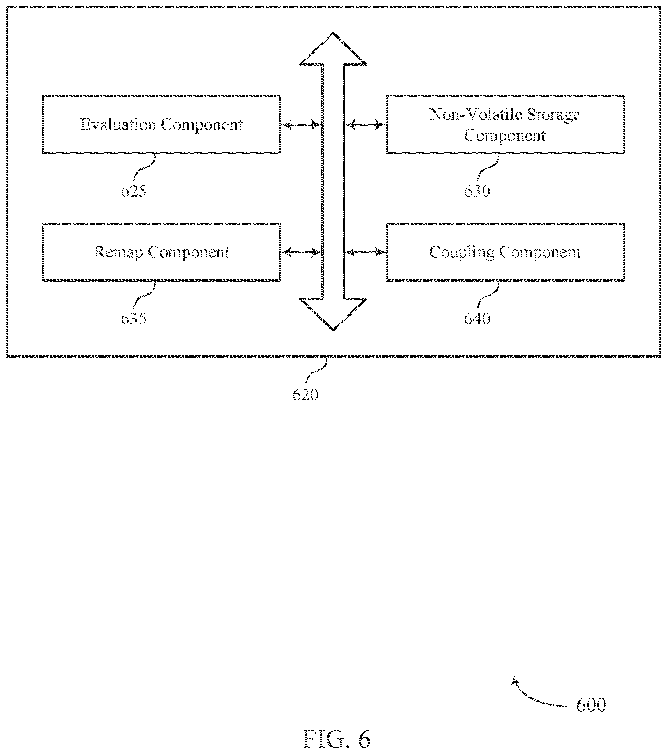

**FIG. 6** shows a block diagram 600 of a system 620 that supports sparing techniques in stacked memory architectures in accordance with examples as disclosed herein. The system 620 may be an example of aspects of a system as described with reference to FIGs. 1 through 5. The system 620, or various components thereof (e.g., an interface block 220, circuitry of an interface block 220, an interface block 245, circuitry of an interface block 245), may be an example of means for performing various aspects of sparing techniques in stacked memory architectures as described herein. For example, the system 620 may include an evaluation component 625, a non-volatile storage component 630, a remap component 635, a coupling component 640, or any combination thereof. In some examples, at least a portion of the system 620 (e.g., at least a portion of the evaluation component 625, at least a portion of the non-volatile storage component 630, at least a portion of the remap component 635, or a combination thereof may be included in a semiconductor system, such as a system 200. Additionally, or alternatively, at least a portion of the system 620 (e.g., at least a portion of the evaluation component 625, at least a portion of the non-volatile storage component 630, at least a portion of the remap component 635, at least a portion of the coupling component 640, or a combination thereof) may be implemented by a manufacturing system or one or more controllers associated with a manufacturing system. For example, in some cases, one or more operations performed by the evaluation component 625, the non-volatile storage component 630, the coupling component 640, or a combination thereof, may be performed by a manufacturing system or one or more controllers associated with a manufacturing system. Each of these components, or components of subcomponents thereof (e.g., one or more processors, one or more memories), may communicate, directly or indirectly, with one another (e.g., via one or more buses).

The evaluation component 625 (e.g., of an interface block 220, of an interface block 245, of a logic block 230, of a manufacturing system) may be configured as or otherwise support a means for evaluating function of each of a plurality of array dies (e.g., dies 240). The non-volatile storage component 630 (e.g., of an interface block 220, of an interface block 245, of a logic block 230, of a manufacturing system) may be configured as or otherwise support a means for setting, based on the evaluating, one or more non-volatile storage elements of the plurality of array dies (e.g., of a non-volatile storage 270) to indicate an error associated with one or more of the plurality of array dies. The remap component 635 (e.g., of an interface block 220, of a logic block 230, of a manufacturing system) may be configured as or otherwise support a means for remapping access of the plurality of array dies, using logic circuitry (e.g., of a logic block 230) of a logic die (e.g., a die 205) that is coupled with the plurality of array dies, from one or more first memory arrays (e.g., memory arrays 250, channels 505, pseudo-channels 515, banks 520) of the plurality of array dies to one or more second memory arrays (e.g., memory arrays 250, channels 505, pseudo-channels 515, banks 520) of the plurality of array dies based on setting the one or more non-volatile storage elements.

In some examples, the coupling component 640 may be configured as or otherwise support a means for coupling, after evaluating the function of each of the plurality of array dies, the plurality of array dies in a stack along a direction (e.g., in a stack 410).

In some examples, the coupling component 640 may be configured as or otherwise support a means for coupling the plurality of array dies in a stack along a direction (e.g., in a stack 410), and evaluating the function of each of the plurality of array dies may be performed after the coupling.

In some examples, the coupling component 640 may be configured as or otherwise support a means for coupling the plurality of array dies and the logic die (e.g., in a stack 420, in a stack 425), and evaluating the function of each of the plurality of array dies may be performed after the coupling.

In some examples, to support setting the one or more non-volatile storage elements, the non-volatile storage component 630 may be configured as or otherwise support a means for setting one or more one-time programmable storage elements (e.g., fuses, antifuses, or a combination thereof) of the plurality of array dies to indicate the error.

In some examples, to support remapping access of the plurality of array dies, the remap component 635 may be configured as or otherwise support a means for remapping accessing from a first array die of the plurality of array dies that includes the one or more first memory arrays to a second array die of the plurality of array dies that includes the one or more second memory arrays.

In some examples, to support remapping access of the plurality of array dies, the remap component 635 may be configured as or otherwise support a means for remapping access from a first interface (e.g., a first interface block 245) of an array die of the plurality of array dies, the first interface associated with accessing the one or more first memory arrays, to a second interface (e.g., a second interface block 245) of the array die, the second interface associated with accessing the one or more second memory arrays.

In some examples, the logic die includes a plurality of second interfaces (e.g., interface blocks 220) each associated with a respective plurality of channels (e.g., channels 505, buses 221, buses 246, buses 255, buses 301, buses 302, buses 303, buses 304) for communications with a respective first interface (e.g., an interface block 245) of one of the plurality of array dies, the respective plurality of channels including a command channel (e.g., a bus 301) and a plurality of data channels (e.g., buses 303) operable to communicate data with at least one memory array corresponding to the respective first interface. In some examples, to support remapping access of the plurality of array dies, the remap component 635 may be configured as or otherwise support a means for remapping accessing from a first data channel of the respective plurality of channels associated with one second interface to a second data channel of the respective plurality of channels associated with another second interface.

In some examples, each array die of the plurality of array dies includes one or more memory arrays that each include one or more banks of memory cells (e.g., banks 520). In some examples, to support remapping access of the plurality of array dies, the remap component 635 may be configured as or otherwise support a means for remapping access from one or more first banks included in the one or more first memory arrays to one or more second banks included in the one or more second memory arrays.

In some examples, the described functionality of the system 620, or various components thereof, may be supported by or may refer to at least a portion of at least one processor, where such at least one processor may include one or more processing elements (e.g., a controller, a microprocessor, a microcontroller, a digital signal processor, a state machine, discrete gate logic, discrete transistor logic, discrete hardware components, or any combination of one or more of such elements). In some examples, the described functionality of the system 620, or various components thereof, may be implemented at least in part by instructions (e.g., stored in memory, non-transitory computer-readable medium) executable by such at least one processor.

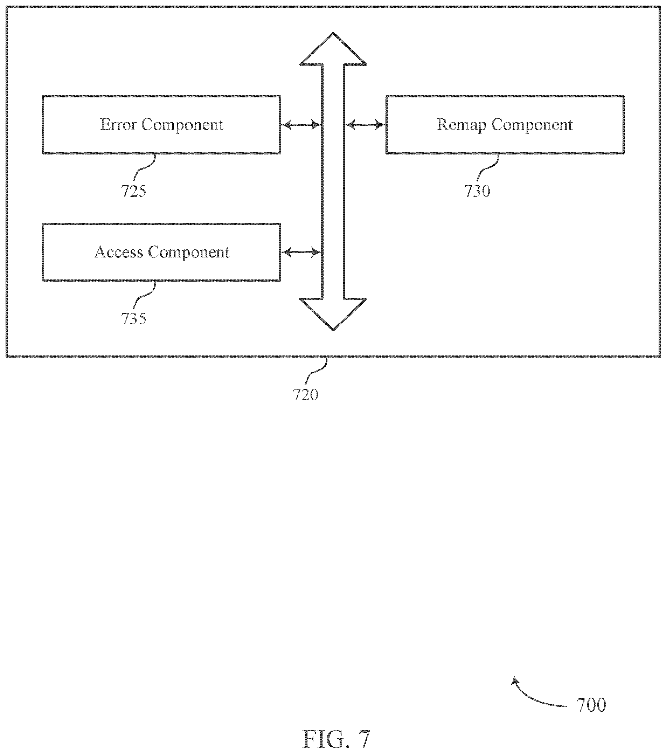

**FIG. 7** shows a block diagram 700 of a logic die 720 that supports sparing techniques in stacked memory architectures in accordance with examples as disclosed herein. The logic die 720 may be an example of aspects of a logic die (e.g., a die 205) as described with reference to FIGs. 1 through 5. The logic die 720, or various components thereof (e.g., an interface block 220, a logic block 230), may be an example of means for performing various aspects of sparing techniques in stacked memory architectures as described herein. For example, the logic die 720 (e.g., an interface block 220, a logic block 230, or a combination thereof) may include an error component 725, a remap component 730, an access component 735, or any combination thereof. Each of these components, or components of subcomponents thereof (e.g., one or more processors, one or more memories), may communicate, directly or indirectly, with one another (e.g., via one or more buses).

The error component 725 may be configured as or otherwise support a means for detecting, by logic circuitry (e.g., a logic block 230) of a logic die (e.g., a die 205) stacked with a plurality of array dies (e.g., dies 240), an error associated with one or more first memory arrays (e.g., memory arrays 250, channels 505, pseudo-channels 515, banks 520) of the plurality of array dies. The remap component 730 may be configured as or otherwise support a means for remapping, by the logic circuitry based on detecting the error, access of the plurality of array dies from the one or more first memory arrays using a first interface (e.g., a first interface block 220) of the logic die to one or more second memory arrays (e.g., memory arrays 250, channels 505, pseudo-channels 515, banks 520) of the plurality of array dies using a second interface (e.g., a second interface block 220) of the logic die. The access component 735 may be configured as or otherwise support a means for accessing, using the second interface, the one or more second memory arrays based on the remapping.

In some examples, to support detecting the error, the error component 725 may be configured as or otherwise support a means for accessing non-volatile storage (e.g., non-volatile storage 235, non-volatile storage 270) associated with the one or more first memory arrays, where one or more non-volatile storage elements of the non-volatile storage indicate the error.

In some examples, to support detecting the error, the error component 725 may be configured as or otherwise support a means for determining the error associated with the one or more first memory arrays based on an attempt to access the one or more first memory arrays using the first interface of the logic die.

In some examples, to support remapping access of the plurality of array dies, the remap component 730 may be configured as or otherwise support a means for remapping accessing from a first array die of the plurality of array dies that includes the one or more first memory arrays to a second array die of the plurality of array dies that includes the one or more second memory arrays.

In some examples, to support remapping access of the plurality of array dies, the remap component 730 may be configured as or otherwise support a means for remapping access from a third interface (e.g., a first interface block 245) of an array die of the plurality of array dies, the third interface associated with accessing the one or more first memory arrays, to a fourth interface (e.g., a second interface block 245) of the array die, the fourth interface associated with accessing the one or more second memory arrays.

In some examples, the first interface and the second interface are each associated with a respective plurality of channels (e.g., channels 505), the respective plurality of channels including a command channel (e.g., a bus 301) and a plurality of data channels (e.g., buses 303) operable to communicate data with at least one memory array corresponding to the interface. In some examples, remapping access of the plurality of array dies includes remapping access from a first data channel of the respective plurality of channels associated with the first interface to a second data channel of the respective plurality of channels associated with the second interface.

In some examples, each array die of the plurality of array dies includes one or more memory arrays that each include one or more banks of memory cells (e.g., banks 520). In some examples, remapping access of the plurality of array dies includes remapping access from one or more first banks included in the one or more first memory arrays to one or more second banks included in the one or more second memory arrays.

In some examples, the described functionality of the logic die 720, or various components thereof, may be supported by or may refer to at least a portion of at least one processor, where such at least one processor may include one or more processing elements (e.g., a controller, a microprocessor, a microcontroller, a digital signal processor, a state machine, discrete gate logic, discrete transistor logic, discrete hardware components, or any combination of one or more of such elements). In some examples, the described functionality of the logic die 720, or various components thereof, may be implemented at least in part by instructions (e.g., stored in memory, non-transitory computer-readable medium) executable by such at least one processor.

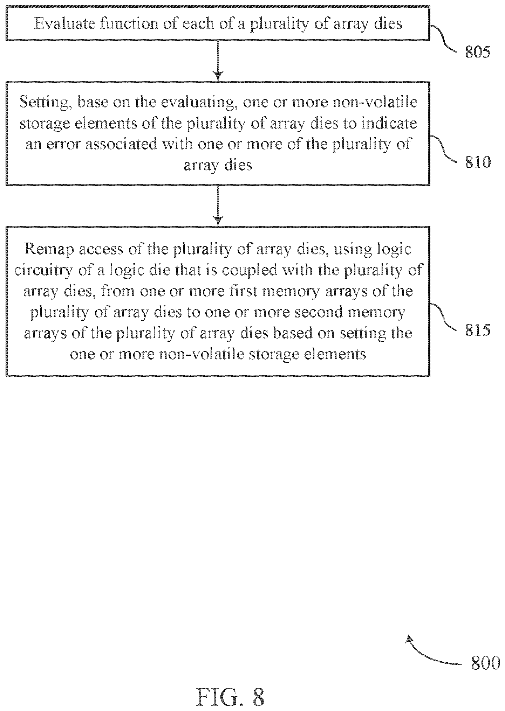

**FIG. 8** shows a flowchart illustrating a method 800 that supports sparing techniques in stacked memory architectures in accordance with examples as disclosed herein. The operations of method 800 may be implemented by a system or its components as described herein (e.g., a die 205, a die 240, a logic block 230). For example, the operations of method 800 may be performed by a system as described with reference to FIGs. 1 through 6. In some examples, a system may execute a set of instructions to control the functional elements of the device to perform the described functions. Additionally, or alternatively, the system may perform aspects of the described functions using special-purpose hardware. In some examples, one or more operations of method 800 may be implemented by a manufacturing system or one or more controllers associated with a manufacturing system. In some examples, one or more controllers may execute a set of instructions to control one or more functional elements of the manufacturing system to perform the described functions. Additionally, or alternatively, one or more controllers may perform aspects of the described functions using special-purpose hardware.

At 805, the method may include evaluating function of each of a plurality of array dies. In some examples, aspects of the operations of 805 may be performed by an evaluation component 625 as described with reference to FIG. 6. For example, respective functions of dies 240 of a die stack (e.g., in a stack 410, in a stack 420, in a stack 425) may be evaluated. In some examples, aspects of the operations of 805 may be performed by a manufacturing system or one or more controllers associated with a manufacturing system.

At 810, the method may include setting, based on the evaluating, one or more non-volatile storage elements of the plurality of array dies to indicate an error associated with one or more of the plurality of array dies. In some examples, aspects of the operations of 810 may be performed by a non-volatile storage component 630 as described with reference to FIG. 6. For example, non-volatile storage elements of one or more non-volatile storages 270 or a non-volatile storage 235 may be set (e.g., by an interface block 220, by an interface block 245, by a logic block 230) to indicate an error associated with one or more of the dies 240 of the stack. In some examples, aspects of the operations of 805 may be performed by a manufacturing system or one or more controllers associated with a manufacturing system.

At 815, the method may include remapping access of the plurality of array dies, using logic circuitry of a logic die that is coupled with the plurality of array dies, from one or more first memory arrays of the plurality of array dies to one or more second memory arrays of the plurality of array dies based on setting the one or more non-volatile storage elements. For example, a logic block 230 of a die 205 coupled with the dies 240 may remap accessing of the dies 240 from one or more first memory arrays (e.g., memory arrays 250, channels 505, pseudo-channels 515, banks 520) of the dies 240 to one or more second memory arrays (e.g., memory arrays 250, channels 505, pseudo-channels 515, banks 520) of the dies 240 based on setting the non-volatile storage elements of the one or more non-volatile storages 270. In some examples, aspects of the operations of 815 may be performed by a remap component 635 as described with reference to FIG. 6.

In some examples, an apparatus as described herein may perform a method or methods, such as the method 800. The apparatus may include features, circuitry, logic, means, or instructions (e.g., a non-transitory computer-readable medium storing instructions executable by a processor), or any combination thereof for performing the following aspects of the present disclosure. In some examples, one or more the following aspects may be performed by a manufacturing system that may include features, circuitry, logic, means, or instructions (e.g., a non-transitory computer-readable medium storing instructions executable by one or more controllers to control one or more functional elements of the manufacturing system), or any combination thereof for performing the one or more aspects.

Aspect 1: A method, apparatus (e.g., a manufacturing system), or non-transitory computer-readable medium including operations, features, circuitry, logic, means, or instructions, or any combination thereof for evaluating function of each of a plurality of array dies; setting, based on the evaluating, one or more non-volatile storage elements of the plurality of array dies to indicate an error associated with one or more of the plurality of array dies; and remapping access of the plurality of array dies, using logic circuitry of a logic die that is coupled with the plurality of array dies, from one or more first memory arrays of the plurality of array dies to one or more second memory arrays of the plurality of array dies based on setting the one or more non-volatile storage elements.

Aspect 2: The method, apparatus (e.g., manufacturing system), or non-transitory computer-readable medium of aspect 1, further including operations, features, circuitry, logic, means, or instructions, or any combination thereof for coupling, after evaluating the function of each of the plurality of array dies, the plurality of array dies in a stack along a direction.

Aspect 3: The method, apparatus (e.g., manufacturing system), or non-transitory computer-readable medium of any of aspects 1 through 2, further including operations, features, circuitry, logic, means, or instructions, or any combination thereof for coupling the plurality of array dies in a stack along a direction, where evaluating the function of each of the plurality of array dies is performed after the coupling.

Aspect 4: The method, apparatus (e.g., manufacturing system), or non-transitory computer-readable medium of any of aspects 1 through 3, further including operations, features, circuitry, logic, means, or instructions, or any combination thereof for coupling the plurality of array dies and the logic die, where evaluating the function of each of the plurality of array dies is performed after the coupling.

Aspect 5: The method, apparatus (e.g., manufacturing system), or non-transitory computer-readable medium of any of aspects 1 through 4, where setting the one or more non-volatile storage elements includes operations, features, circuitry, logic, means, or instructions, or any combination thereof for setting one or more one-time programmable storage elements of the plurality of array dies to indicate the error.

Aspect 6: The method, apparatus, or non-transitory computer-readable medium of any of aspects 1 through 5, where remapping access of the plurality of array dies includes operations, features, circuitry, logic, means, or instructions, or any combination thereof for remapping accessing from a first array die of the plurality of array dies that includes the one or more first memory arrays to a second array die of the plurality of array dies that includes the one or more second memory arrays.

Aspect 7: The method, apparatus, or non-transitory computer-readable medium of any of aspects 1 through 6, where remapping access of the plurality of array dies includes operations, features, circuitry, logic, means, or instructions, or any combination thereof for remapping access from a first interface of an array die of the plurality of array dies, the first interface associated with accessing the one or more first memory arrays, to a second interface of the array die, the second interface associated with accessing the one or more second memory arrays.

Aspect 8: The method, apparatus, or non-transitory computer-readable medium of any of aspects 1 through 7, where the logic die includes a plurality of second interfaces each associated with a respective plurality of channels for communications with a respective first interface of one of the plurality of array dies, the respective plurality of channels including a command channel and a plurality of data channels operable to communicate data with at least one memory array corresponding to the respective first interface, and remapping access of the plurality of array dies includes remapping accessing from a first data channel of the respective plurality of channels associated with one second interface to a second data channel of the respective plurality of channels associated with another second interface.

Aspect 9: The method, apparatus, or non-transitory computer-readable medium of any of aspects 1 through 8, where each array die of the plurality of array dies includes one or more memory arrays that each include one or more banks of memory cells, and remapping access of the plurality of array dies includes remapping access from one or more first banks included in the one or more first memory arrays to one or more second banks included in the one or more second memory arrays.

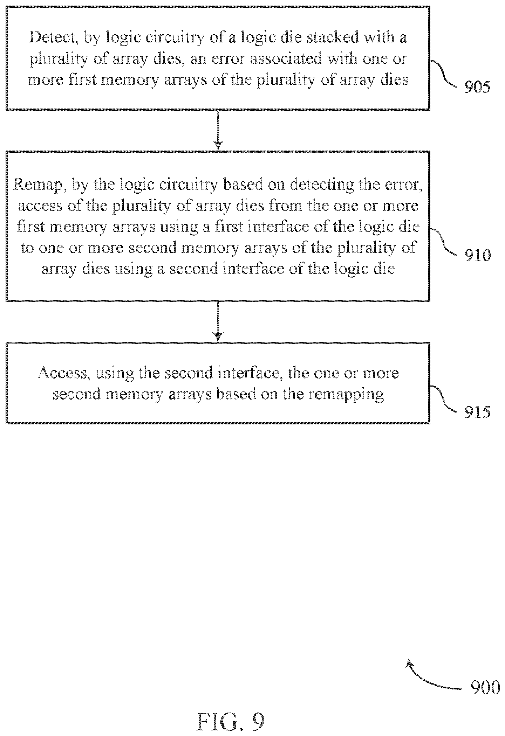

**FIG. 9** shows a flowchart illustrating a method 900 that supports sparing techniques in stacked memory architectures in accordance with examples as disclosed herein. The operations of method 900 may be implemented by a logic die (e.g., a die 205) or its components as described herein (e.g., an interface block 220, a logic block 230). For example, the operations of method 900 may be performed by a logic die as described with reference to FIGs. 1 through 5 and 7. In some examples, a logic die may execute a set of instructions to control the functional elements of the device to perform the described functions. Additionally, or alternatively, the logic die may perform aspects of the described functions using special-purpose hardware.

At 905, the method may include detecting, by logic circuitry of a logic die stacked with a plurality of array dies, an error associated with one or more first memory arrays of the plurality of array dies. For example, a logic block 230 of a die 205 stacked with a set of dies 240 (e.g., in a stack 425) may detect an error associated with one or more first memory arrays (e.g., memory arrays 250, channels 505, pseudo-channels 515, banks 520) of the dies 240. In some examples, aspects of the operations of 905 may be performed by an error component 725 as described with reference to FIG. 7.

At 910, the method may include remapping, by the logic circuitry based on detecting the error, access of the plurality of array dies from the one or more first memory arrays using a first interface of the logic die to one or more second memory arrays of the plurality of array dies using a second interface of the logic die. For example, based on detecting the error, the logic block 230 may remap access of the dies 240 from one or more first memory arrays (e.g., memory arrays 250, channels 505, pseudo-channels 515, banks 520) using a first interface block 220 of the die 205 to one or more second memory arrays (e.g., memory arrays 250, channels 505, pseudo-channels 515, banks 520) using a second interface block 220 of the die 205. may In some examples, aspects of the operations of 910 may be performed by a remap component 730 as described with reference to FIG. 7.

At 915, the method may include accessing, using the second interface, the one or more second memory arrays based on the remapping. For example, the second interface block 220 may access the one or more second memory arrays (e.g., memory arrays 250, channels 505, pseudo-channels 515, banks 520) based on the remapping. In some examples, aspects of the operations of 915 may be performed by an access component 735 as described with reference to FIG. 7.

In some examples, an apparatus as described herein may perform a method or methods, such as the method 900. The apparatus may include features, circuitry, logic, means, or instructions (e.g., a non-transitory computer-readable medium storing instructions executable by a processor), or any combination thereof for performing the following aspects of the present disclosure:

Aspect 10: A method, apparatus, or non-transitory computer-readable medium including operations, features, circuitry, logic, means, or instructions, or any combination thereof for detecting, by logic circuitry of a logic die stacked with a plurality of array dies, an error associated with one or more first memory arrays of the plurality of array dies; remapping, by the logic circuitry based on detecting the error, access of the plurality of array dies from the one or more first memory arrays using a first interface of the logic die to one or more second memory arrays of the plurality of array dies using a second interface of the logic die; and accessing, using the second interface, the one or more second memory arrays based on the remapping.

Aspect 11: The method, apparatus, or non-transitory computer-readable medium of aspect 10, where detecting the error includes operations, features, circuitry, logic, means, or instructions, or any combination thereof for accessing non-volatile storage associated with the one or more first memory arrays, where one or more non-volatile storage elements of the non-volatile storage indicate the error.

Aspect 12: The method, apparatus, or non-transitory computer-readable medium of any of aspects 10 through 11, where detecting the error includes operations, features, circuitry, logic, means, or instructions, or any combination thereof for determining the error associated with the one or more first memory arrays based on an attempt to access the one or more first memory arrays using the first interface of the logic die.

Aspect 13: The method, apparatus, or non-transitory computer-readable medium of any of aspects 10 through 12, where remapping access of the plurality of array dies includes operations, features, circuitry, logic, means, or instructions, or any combination thereof for remapping accessing from a first array die of the plurality of array dies that includes the one or more first memory arrays to a second array die of the plurality of array dies that includes the one or more second memory arrays.

Aspect 14: The method, apparatus, or non-transitory computer-readable medium of any of aspects 10 through 13, where remapping access of the plurality of array dies includes operations, features, circuitry, logic, means, or instructions, or any combination thereof for remapping access from a third interface of an array die of the plurality of array dies, the third interface associated with accessing the one or more first memory arrays, to a fourth interface of the array die, the fourth interface associated with accessing the one or more second memory arrays.

Aspect 15: The method, apparatus, or non-transitory computer-readable medium of any of aspects 10 through 14, where the first interface and the second interface are each associated with a respective plurality of channels, the respective plurality of channels including a command channel and a plurality of data channels operable to communicate data with at least one memory array corresponding to the interface, and remapping access of the plurality of array dies includes remapping access from a first data channel of the respective plurality of channels associated with the first interface to a second data channel of the respective plurality of channels associated with the second interface.

Aspect 16: The method, apparatus, or non-transitory computer-readable medium of any of aspects 10 through 15, where each array die of the plurality of array dies includes one or more memory arrays that each include one or more banks of memory cells, and remapping access of the plurality of array dies includes remapping access from one or more first banks included in the one or more first memory arrays to one or more second banks included in the one or more second memory arrays.

It should be noted that the aspects described herein describe possible implementations, and that the operations and the steps may be rearranged or otherwise modified and that other implementations are possible. Further, portions from two or more of the methods may be combined.

A system is described. The following provides an overview of aspects of the apparatus as described herein:

Aspect 17: A system, including: a plurality of array dies stacked along a direction, each array die including: one or more memory arrays; and one or more first interfaces, each first interface including first circuitry operable to access at least one corresponding memory array of the one or more memory arrays; and a logic die coupled with the plurality of array dies, the logic die including: a plurality of second interfaces, each second interface including second circuitry operable to communicate access signaling with a respective first interface of the plurality of array dies to access the at least one memory array corresponding to the respective first interface; and logic circuitry operable to remap accessing of the plurality of array dies from one or more first memory arrays of the plurality of array dies using a first of the plurality of second interfaces to one or more second memory arrays of the plurality of array dies using a second of the plurality of second interfaces based on an error associated with access of the one or more first memory arrays.

Aspect 18: The system of aspect 17, where, to remap accessing of the plurality of array dies, the logic circuitry is operable to: remap accessing from one of the first interfaces of an array die of the plurality of array dies that includes the first circuitry operable to access the one or more first memory arrays to another of the first interfaces of the array die that includes the first circuitry operable to access the one or more second memory arrays.

Aspect 19: The system of any of aspects 17 through 18, where, to remap accessing of the plurality of array dies, the logic circuitry is operable to: remap accessing from a first array die of the plurality of array dies that includes the one or more first memory arrays to a second array die of the plurality of array dies that includes the one or more second memory arrays.

Aspect 20: The system of any of aspects 17 through 19, where, to remap accessing of the plurality of array dies, the logic circuitry is operable to: remap access from all of the first interfaces of a first array die of the plurality of array dies to respective first interfaces of a second array die of the plurality of array dies.

Aspect 21: The system of any of aspects 17 through 20, where: each second interface is associated with a respective plurality of channels for communications with the respective first interface, the respective plurality of channels including a command channel and a plurality of data channels operable to communicate data with the at least one memory array corresponding to the respective first interface; and, to remap accessing of the plurality of array dies, the logic circuitry is operable to remap accessing from a first data channel of the respective plurality of channels associated with one second interface to a second data channel of the respective plurality of channels associated with another second interface.

Aspect 22: The system of aspect 21, where the logic circuitry is further operable to: configure the one second interface, the other second interface, or both to communicate shared command signaling via the command channel associated with the one second interface and via the command channel associated with the other second interface.

Aspect 23: The system of any of aspects 17 through 22, where: each of the one or more memory arrays includes one or more banks of memory cells; and, to remap accessing of the plurality of array dies, the logic circuitry is operable to remap accessing from one or more first banks included in the one or more first memory arrays to one or more second banks included in the one or more second memory arrays.

Aspect 24: The system of any of aspects 17 through 23, where the logic circuitry is further operable to: identify the error associated with access of the one or more first memory arrays based on accessing a non-volatile storage of an array die that includes the one or more first memory arrays; and remap the accessing of the plurality of array dies from the one or more first memory arrays to the one or more second memory arrays based on the identification.

Aspect 25: The system of any of aspects 17 through 24, where the logic circuitry is further operable to: identify the error associated with access of the one or more first memory arrays based on accessing a non-volatile storage of an array die that includes the one or more second memory arrays; and remap the accessing of the plurality of array dies from the one or more first memory arrays to the one or more second memory arrays based on the identification.

Aspect 26: The system of any of aspects 17 through 25, where the logic circuitry is further operable to: determine the error associated with access of the one or more first memory arrays based on an attempt to access the one or more first memory arrays by one of the plurality of second interfaces; and remap the accessing of the plurality of array dies from the one or more first memory arrays to the one or more second memory arrays based on the determination.

Aspect 27: The system of aspect 26, where the logic circuitry is further operable to: store an indication of the determined error in a non-volatile storage of the logic die, or one or more of the array dies, or a combination thereof.

Aspect 28: The system of any of aspects 17 through 27, where, to remap the accessing of the plurality of array dies, the logic circuitry is operable to: remap a portion of an address space accessible by a host system from the one or more first memory arrays to the one or more second memory arrays.

Aspect 29: The system of any of aspects 17 through 28, where the one or more second memory arrays are included in an array die of the plurality of array dies that is located nearest to the logic die.

Aspect 30: The system of any of aspects 17 through 29, where the one or more second memory arrays are included in an array die of the plurality of array dies over which other array dies of the plurality of array dies are stacked.

A system is described. The following provides an overview of aspects of the apparatus as described herein:

Aspect 31: A system, including: a plurality of array dies stacked along a direction, each array die including one or more memory arrays and a non-volatile storage; and a logic die coupled with the plurality of array dies, the logic die including: a plurality of interfaces including circuitry operable to communicate access signaling to access memory arrays of the plurality of array dies; and logic circuitry coupled with the plurality of interfaces and operable to: identify an error associated with one or more first memory arrays of the plurality of array dies based on accessing the non-volatile storage of one or more of the plurality of array dies; and remap, based on identifying the error, accessing from the one or more first memory arrays using a first interface of the plurality of interfaces to one or more second memory arrays of the plurality of array dies using a second interface of the plurality of interfaces.

A system is described. The following provides an overview of aspects of the apparatus as described herein:

Aspect 32: A system, including: a plurality of array dies stacked along a direction, each array die including one or more memory arrays; and a logic die coupled with the plurality of array dies, the logic die including: a plurality of interfaces including circuitry operable to communicate access signaling to access memory arrays of the plurality of array dies; and logic circuitry coupled with the plurality of interfaces and operable to: detect an error based on an attempt to access one or more first memory arrays of the plurality of array dies using a first interface of the plurality of interfaces; and remap, based on detecting the error, accessing of the plurality of array dies from the one or more first memory arrays using the first interface to one or more second memory arrays of the plurality of array dies using a second interface of the plurality of interfaces.

Information and signals described herein may be represented using any of a variety of different technologies and techniques. For example, data, instructions, commands, information, signals, bits, or symbols of signaling that may be referenced throughout the above description may be represented by voltages, currents, electromagnetic waves, magnetic fields or particles, optical fields or particles, or any combination thereof. Some drawings may illustrate signals as a single signal; however, the signal may represent a bus of signals, where the bus may have a variety of bit widths.

The terms "electronic communication," "conductive contact," "connected," and "coupled" may refer to a relationship between components that supports the flow of signals between the components. Components are considered in electronic communication with (e.g., in conductive contact with, connected with, coupled with) one another if there is any electrical path (e.g., conductive path) between the components that can, at any time, support the flow of signals (e.g., charge, current, voltage) between the components. A conductive path between components that are in electronic communication with each other (e.g., in conductive contact with, connected with, coupled with) may be an open circuit or a closed circuit based on the operation of the device that includes the connected components. A conductive path between connected components may be a direct conductive path between the components or may be an indirect conductive path that includes intermediate components, such as switches, transistors, or other components. In some examples, the flow of signals between the connected components may be interrupted for a time, for example, using one or more intermediate components such as switches or transistors.

The term "isolated" may refer to a relationship between components in which signals are not presently capable of flowing between the components. Components are isolated from each other if there is an open circuit between them. For example, two components separated by a switch that is positioned between the components are isolated from each other when the switch is open. When a component isolates two components, the component may initiate a change that prevents signals from flowing between the other components using a conductive path that previously permitted signals to flow.

The term "coupling" (e.g., "electrically coupling") may refer to condition of moving from an open-circuit relationship between components in which signals are not presently capable of being communicated between the components (e.g., over a conductive path) to a closed-circuit relationship between components in which signals are capable of being communicated between components (e.g., over the conductive path). When a component, such as a controller, couples other components together, the component may initiate a change that allows signals to flow between the other components over a conductive path that previously did not permit signals to flow.

The description set forth herein, in connection with the appended drawings, describes example configurations and does not represent all the examples that may be implemented or that are within the scope of the claims. The detailed description includes specific details to provide an understanding of the described techniques. These techniques, however, may be practiced without these specific details. In some instances, well-known structures and devices are shown in block diagram form to avoid obscuring the concepts of the described examples.

In the appended figures, similar components or features may have the same reference label. Similar components may be distinguished by following the reference label by one or more dashes and additional labeling that distinguishes among the similar components. If just the first reference label is used in the specification, the description is applicable to any one of the similar components having the same first reference label irrespective of the additional reference labels.

The functions described herein may be implemented in hardware, software executed by a processing system (e.g., one or more processors, one or more controllers, control circuitry processing circuitry, logic circuitry), firmware, or any combination thereof. If implemented in software executed by a processing system, the functions may be stored on or transmitted over as one or more instructions (e.g., code) on a computer-readable medium. Due to the nature of software, functions described herein can be implemented using software executed by a processing system, hardware, firmware, hardwiring, or combinations of any of these. Features implementing functions may be physically located at various positions, including being distributed such that portions of functions are implemented at different physical locations.

Illustrative blocks and modules described herein may be implemented or performed with one or more processors, such as a DSP, an ASIC, an FPGA, discrete gate logic, discrete transistor logic, discrete hardware components, other programmable logic device, or any combination thereof designed to perform the functions described herein. A processor may be an example of a microprocessor, a controller, a microcontroller, a state machine, or other types of processor. A processor may also be implemented as at least one of one or more computing devices (e.g., a combination of a DSP and a microprocessor, multiple microprocessors, one or more microprocessors in conjunction with a DSP core, or any other such configuration).

As used herein, including in the claims, "or" as used in a list of items (for example, a list of items prefaced by a phrase such as "at least one of" or "one or more of') indicates an inclusive list such that, for example, a list of at least one of A, B, or C means A or B or C or AB or AC or BC or ABC (i.e., A and B and C). Also, as used herein, the phrase "based on" shall not be construed as a reference to a closed set of conditions. For example, an exemplary step that is described as "based on condition A" may be based on both a condition A and a condition B without departing from the scope of the present disclosure. In other words, as used herein, the phrase "based on" shall be construed in the same manner as the phrase "based at least in part on."

As used herein, including in the claims, the article "a" before a noun is openended and understood to refer to "at least one" of those nouns or "one or more" of those nouns. Thus, the terms "a," "at least one," "one or more," "at least one of one or more" may be interchangeable. For example, if a claim recites "a component" that performs one or more functions, each of the individual functions may be performed by a single component or by any combination of multiple components. Thus, the term "a component" having characteristics or performing functions may refer to "at least one of one or more components" having a particular characteristic or performing a particular function. Subsequent reference to a component introduced with the article "a" using the terms "the" or "said" may refer to any or all of the one or more components. For example, a component introduced with the article "a" may be understood to mean "one or more components," and referring to "the component" subsequently in the claims may be understood to be equivalent to referring to "at least one of the one or more components." Similarly, subsequent reference to a component introduced as "one or more components" using the terms "the" or "said" may refer to any or all of the one or more components. For example, referring to "the one or more components" subsequently in the claims may be understood to be equivalent to referring to "at least one of the one or more components."

Computer-readable media includes both non-transitory computer storage media and communication media including any medium that facilitates transfer of a computer program from one place to another. A non-transitory storage medium may be any available medium, or combination of multiple media, that can be accessed by a computer. By way of example, and not limitation, non-transitory computer-readable media can comprise RAM, ROM, electrically erasable programmable read-only memory (EEPROM), optical disk storage, magnetic disk storage or other magnetic storage devices, or any other non-transitory medium or combination of media that can be used to carry or store desired program code means in the form of instructions or data structures and that can be accessed by a computer, or a processor.

The descriptions and drawings are provided to enable a person having ordinary skill in the art to make or use the disclosure. Various modifications to the disclosure will be apparent to the person having ordinary skill in the art, and the techniques disclosed herein may be applied to other variations without departing from the scope of the disclosure. Thus, the disclosure is not limited to the examples and designs described herein but is to be accorded the broadest scope consistent with the principles and novel features disclosed herein.

## Claims

1. A system, comprising:
a plurality of array dies (240) stacked along a direction, each array die comprising:
one or more memory arrays (250); and
one or more first interfaces, each first interface (245) comprising first circuitry operable to access at least one corresponding memory array of the one or more memory arrays; and
a logic die (205) coupled with the plurality of array dies, the logic die comprising:
a plurality of second interfaces (220), each second interface comprising second circuitry operable to communicate access signaling with a respective first interface of the plurality of array dies (240) to access the at least one memory array (250) corresponding to the respective first interface; and
logic circuitry (230) operable to remap accessing of the plurality of array dies from one or more first memory arrays (250; 505; 515; 520) of the plurality of array dies using a first of the plurality of second interfaces to one or more second memory arrays (250; 505; 515; 520) of the plurality of array dies using a second of the plurality of second interfaces based on an error associated with access of the one or more first memory arrays.

2. The system of claim 1, wherein, to remap accessing of the plurality of array dies, the logic circuitry (230) is operable to:
remap accessing from one of the first interfaces (245) of an array die (240-c-1) of the plurality of array dies that includes the first circuitry operable to access the one or more first memory arrays (250) to another of the first interfaces (245) of the array die (240-c-2) that includes the first circuitry operable to access the one or more second memory arrays.

3. The system of claim 1, wherein, to remap accessing of the plurality of array dies, the logic circuitry is operable to:
remap accessing from a first array die (240-c-1) of the plurality of array dies that includes the one or more first memory arrays to a second array die (240-c-2) of the plurality of array dies that includes the one or more second memory arrays.

4. The system of claim 1, wherein, to remap accessing of the plurality of array dies (240), the logic circuitry is operable to:
remap access from all of the first interfaces (245) of a first array die of the plurality of array dies to respective first interfaces (245) of a second array die of the plurality of array dies.

5. The system of claim 1, wherein:
each second interface is associated with a respective plurality of channels for communications with the respective first interface, the respective plurality of channels (505-a) including a command channel (301-a, 302-a) and a plurality of data channels (303-a, 304-a) operable to communicate data with the at least one memory array (250) corresponding to the respective first interface; and
to remap accessing of the plurality of array dies, the logic circuitry (230) is operable to remap accessing from a first data channel (505-a-1) of the respective plurality of channels (510-a-1) associated with one second interface to a second data channel (505-a-2) of the respective plurality of channels (510-a) associated with another second interface.

6. The system of claim 5, wherein the logic circuitry is further operable to:
configure the one second interface (220), the other second interface (220), or both to communicate shared command signaling via the command channel (505-a) associated with the one second interface and via the command channel associated with the other second interface.

7. The system of claim 1, wherein:
each of the one or more memory arrays (250) comprises one or more banks (520-a) of memory cells; and
to remap accessing of the plurality of array dies (240), the logic circuitry (230) is operable to remap accessing from one or more first banks (520-a-2) included in the one or more first memory arrays to one or more second banks (520-a) included in the one or more second memory arrays.

8. The system of claim 1, wherein the logic circuitry (230) is further operable to:
identify the error associated with access of the one or more first memory arrays based on accessing a non-volatile storage (270) of an array die (240-b) that includes the one or more first memory arrays; and
remap the accessing of the plurality of array dies (240-b) from the one or more first memory arrays to the one or more second memory arrays based on the identification.

9. The system of claim 1, wherein the logic circuitry (230) is further operable to:
determine the error associated with access of the one or more first memory arrays based on an attempt to access the one or more first memory arrays by one of the plurality of second interfaces; and
remap the accessing of the plurality of array dies from the one or more first memory arrays (250; 505; 515; 520) to the one or more second memory arrays (250; 505; 515; 520) based on the determination.

10. The system of claim 9, wherein the logic circuitry is further operable to:
store an indication of the determined error in a non-volatile storage (235; 270) of the logic die (205), or one or more of the array dies (240), or a combination thereof.

11. The system of claim 1, wherein, to remap the accessing of the plurality of array dies (240), the logic circuitry (230) is operable to:
remap a portion of an address space accessible by a host system from the one or more first memory arrays to the one or more second memory arrays.

12. The system of claim 1, wherein the one or more second memory arrays are included in an array die (240) of the plurality of array dies that is located nearest to the logic die (205).

13. A method, comprising:
detecting (905), by logic circuitry (230) of a logic die (205) stacked with a plurality of array dies (240), an error associated with one or more first memory arrays (250; 505; 515; 520) of the plurality of array dies (240);
remapping (910), by the logic circuitry (230) based on detecting the error, access of the plurality of array dies (240) from the one or more first memory arrays (250; 505; 515; 520) using a first interface (220) of the logic die (205) to one or more second memory arrays (250; 505; 515; 520) of the plurality of array dies using a second interface (220) of the logic die (205); and
accessing (915), using the second interface (220), the one or more second memory arrays (250; 505; 515; 520) based on the remapping.

14. The method of claim 13, wherein detecting the error comprises:
accessing non-volatile storage (270) associated with the one or more first memory arrays (250; 505; 515; 520), wherein one or more non-volatile storage elements of the non-volatile storage (270) indicate the error.

15. The method of claim 13, wherein detecting the error comprises:
determining the error associated with the one or more first memory arrays (250; 505; 515; 520) based on an attempt to access the one or more first memory arrays using the first interface (220) of the logic die.
